# EUROPÄISCHE PATENTSCHRIFT

(11) **EP 2 142 351 B1**
(45) Veröffentlichungstag und Bekanntmachung des Hinweises auf die Patenterteilung: **01.03.2017**
(21) Anmeldenummer: 07856277.4
(22) Anmeldetag: 28.11.2007
(51) Int. Cl.: B29C 45/16, A46D 3/00

(54) **ZAHNBÜRSTE MIT PARTIELL BESCHICHTETER OBERFLÄCHE**
TOOTHBRUSH WITH PARTIALLY COATED SURFACE
BROSSE À DENTS DOTÉE D'UNE SURFACE PARTIELLEMENT REVÊTUE

(30) Priorität: 29.11.2006 EP 06024727
(43) Veröffentlichungstag der Anmeldung: 13.01.2010
(73) Patentinhaber: Trisa Holding AG, 6234 Triengen (CH)
(72) Erfinder: GROSS, Peter, 6204 Sempach-Stadt (CH); HILFIKER, Christian, 6234 Triengen (CH)
(74) Vertreter: Schaad, Balass, Menzl & Partner AG
(86) Internationale Anmeldenummer: PCT/EP2007/010312
(87) Internationale Veröffentlichungsnummer: WO 2008/064873

(56) Entgegenhaltungen:
- EP-A- 1 530 955
- WO-A-00/07482
- WO-A-00/34022
- WO-A-01/96088
- WO-A-99/63859
- WO-A-2004/043669
- DE-A1- 19 535 134

## Beschreibung

Die vorliegende Erfindung betrifft eine Zahnbürste sowie ein Verfahren zum Herstellen einer Zahnbürste gemäss dem Oberbegriff des Patentanspruchs 1 beziehungsweise 21.

Eine Zahnbürste dieser Art ist in der WO 99/63859 offenbart. Ein innerer Körper wird durch Spritzgiessen eines lichtdurchlässigen Materials gebildet. Eine reflektierende Schicht wird auf die Oberfläche des inneren Körpers appliziert und eine äussere Deckschicht kann durch Überspritzen der reflektierenden Schicht aufgebracht werden, wobei die reflektierende Schicht und die Deckschicht Fenster freilassen, durch welche Licht aus dem inneren Körper austreten kann.

Eine weitere Zahnbürste dieser Art ist aus DE 31 05 544 bekannt, sie besteht aus einem aus Kunststoff hergestellten Körper mit der Aufgabe als Handgriff und Kopf für das Tragen der Borsten. Mittels eines elektrogalvanischen Verfahrens ist entweder nur auf dem auswechselbaren Kopf oder, bei einstückiger Ausbildung vom Körper mit Kopf, auf dem Körper und dem Kopf vollflächig eine Silberschicht angebracht.

Galvanische Verfahren oder andere metallische Beschichtungsverfahren können auf die Verwendung von giftigen Stoffen angewiesen sein. Es kann deshalb nicht ausgeschlossen werden, dass giftige Stoffe als Restpartikel auf der metallischen Oberfläche zurückbleiben. Für den Benutzer solcher Zahnbürsten kann davon die Gefahr ausgehen, dass giftige Stoffe durch die Berührung beziehungsweise während der Benutzung in den Körper gelangen.

Weiter kann die Anwesenheit von Metall im Mund bei Berührung mit beispielsweise Amalganplomben aufgrund eines durch statische Ladung verursachten Stromflusses zu einem Schmerzen verursachenden galvanischen Schock führen.

Gemäss der DE 31 05 544 A1 ist die Silberschicht im Kopf der Zahnbürste gerade gewünscht, um die Gefahr von Infektionen in der Mundhöhle zu vermeiden. Sollte entgegen dieser Zielsetzung die bekannte Zahnbürste derart ausgebildet werden, dass sie im Kopf keine Silberschicht aufweist, wäre es notwendig, den nicht mit Silber zu überziehenden Teil der Zahnbürste vor der Galvanikbehandlung - oder allenfalls einer Metalisierung mittels anderem Verfahren - abzudecken, was mit einem grossen manuellen Aufwand verbunden wäre.

In der WO 2001/096088 und in der entsprechenden EP 1 289 729 B1 ist anhand einer Zahnbürste ein Verfahren zum Herstellen eines Formlings offenbart. Eine Schale aus flächenförmigem Metall, Kunststoff oder Metall-Kunststofflaminat oder Verbundwerkstoff und mit wenigstens einem Loch wird in einen ersten Formhohlraum einer ersten Spritzgiessform derart eingelegt, dass sie an der Hohlraumoberfläche anliegt. Dann wird Kunststoffmaterial eingespritzt, so dass das Kunststoffmaterial in Kontakt mit der vorgängig eingelegten Schale fliesst, das verfestigte Kunststoffmaterial an der Schale fixiert ist und die Schale mindestens einen Teil der Aussenfläche des Formlings, beziehungsweise der Zahnbürste bildet. Dabei wird auch eine vom Loch der Schale her durch den Formling hindurch verlaufende Öffnung gebildet. Der Formling wird in einen zweiten Formhohlraum eingeführt. Beim darauffolgenden Einspritzvorgang fliesst weiteres Material, ein gummiartiges Material, in die Öffnung und durch diese, um einen Teil des weiteren Materials zu bilden, das an der Aussenoberfläche der Schale freiliegt. Es ist eine Aufgabe der vorliegenden Erfindung, die bekannte Zahnbürste weiterzubilden und dabei eine Herstellung mit geringem Aufwand zu ermöglichen. Weiter ist es eine Aufgabe, ein entsprechendes Verfahren zur Herstellung einer Zahnbürste zu schaffen.

Diese Aufgabe wird mit einer Zahnbürste gemäss Patentanspruch 1 und einem Verfahren gemäss Anspruch 21 gelöst.

Die erfindungsgemässe Zahnbürste kann im Griffteil eine äussere, freiliegende Oberfläche aufweisen, die zum Teil von einem metallischen Überzug einer ersten Hartkomponente und zum Teil von mindestens einer weiteren Kunststoffkomponente, beispielsweise einer zweiten Hartkomponente und/oder einer weiteren Komponente gebildet ist, welche den metallischen Überzug mindestens bereichsweise überdeckt. Es ist auch denkbar, dass die weitere Kunststoffkomponente den metallischen Überzug im Griffteil vollständig überdeckt. Die metallische Schicht befindet sich in diesem Fall vollständig innerhalb des Zahnbürstenkörpers und ist zwischen der ersten Hartkomponente sowie der zweiten Hartkomponente und eventuellen weiteren Kunststoffkomponenten angeordnet und vollständig abgedeckt.

Das Überdecken des metallischen Überzuges mit einer zweiten Hartkomponente erlaubt die metallische Schicht zu schützen. Dies ist besonders interessant, wenn damit das Anbringen einer Schutzlackschicht, wie dies beim CVD-(Chemical Vapour Deposition) PVD- (Physical Vapour Deposition) oder Sputter- Metallbeschichtungsverfahren benötigt wird, verhindert werden kann oder nur eine besonders dünne und damit fragile Metallschicht aufgebracht werden kann. Dabei kann es sich um Schichtdicken je nach Verfahren von unter 1 Mikrometer handeln.

Die zweite Hartkomponente ist in diesem Fall vorzugsweise transluszent oder transparent, damit die Metallschicht durch die zusätzliche Kunststoffkomponente hindurch noch sichtbar ist. Der umgekehrte Fall ist ebenfalls möglich. Die metallische Schicht wird auf einer transluszenten oder transparenten ersten Hartkomponente auf der ganzen Oberfläche aufgebracht. Anschließend überdeckt eine zweite transparente oder opake Hartkomponente den metallischen Überzug der ersten Hartkomponente ganz oder teilweise.

Gegenüber bekannten Zahnbürsten mit einem Zahnbürstenkörper, welcher vollständig mit einem metallischen Überzug versehen ist, weist die erfindungsgemässe Zahnbürste, neben einer verbesserten Optik und Wertigkeit, insbesondere eine verbesserte Haptik auf. Bei der erfindungsgemässen Zahnbürste können einerseits Oberflächenbereiche, die eine erhöhte Resistenz benötigen, durch den metallischen Überzug gebildet sein und andererseits können Oberflächenbereiche, welche für die Haptik wichtig sind, von der weiteren Kunststoffkomponente gebildet sein. Alternativ oder zusätzlich kann die zweite Hartkomponente dazu verwendet werden, den Herstellungsprozess zu vereinfachen. Anstelle von Schutzlacken, insbesondere im Zusammenhang mit CVD, PVD oder Sputtern zur Herstellung der metallischen Oberfläche, können weitere Kunststoffkomponenten in einem weiteren Spritzgussschritt über die metallische Oberfläche gebracht werden.

Die elektrische Leitfähigkeit des metallischen Überzugs kann beispielsweise in elektrischen Zahnbürsten - oder anderen weiter unten erwähnten elektrischen Körperpflegegeräten - funktional angewendet werden. So ist es denkbar, via den metallischen Überzug Strom vom Griffteil, in welchem eine Batterie, ein Akkumulator, ein Schalter und dergleichen angeordnet ist, zum Halsteil oder Kopfteil zu leiten, wo ein elektrisches Funktionselement, beispielsweise ein Vibrationselement oder ein Elektromotor, aufgenommen sein kann. Um die Nachteile von metallischen Oberflächen in jenen Bereichen der Zahnbürste, welche in die Mundhöhle eingeführt werden, zu vermeiden, kann der metallische Überzug dort von der zweiten Hartkomponente oder einer weichen Komponente überdeckt sein. Die elektrische Leitfähigkeit des metallischen Überzugs kann auch als elektrische Verbindung zu Sensoren und dergleichen oder als Schaltkontakt oder dergleichen dienen. Das gleichzeitige Berühren dieses Schaltkontakts und eines davon galvanisch getrennten elektrischen Leitelements, beispielsweise mit der Hand, kann zu einem geschlossenen Stromkreis führen, der beim Abheben der Hand von der betreffenden Stelle wieder unterbrochen wird.

Zudem ist es möglich, mit dem metallischen Überzug eine spiegelnde Oberfläche zu bilden, beispielsweise am Griffteil oder auf der Rückseite des Kopfteils, welche mit den Zähnen üblicherweise nicht in Berührung kommt. Die spiegelnde Oberfläche kann beispielsweise zur Kontrolle der Zahnreinigung benützt werden; zudem ist es möglich, durch eine dreidimensionale, nicht ebene Formgebung der den metallischen Überzug tragenden Fläche eine Vergrösserung, Verkleinerung oder Verzerrung des mit dem Spiegel zu betrachtenden Objekts zu erreichen. Auch in diesem Fall wird vorgeschlagen, den metallischen Überzug mittels vorzugsweise der zweiten Hartkomponente mindestens teilweise zu überspritzen.

Überdies kann beispielsweise mittels eines Silber enthaltenden metallischen Überzugs ein antibakterieller Effekt erzielt werden.

Der metallische Überzug bildet eine Beschichtung auf der Oberfläche der voluminösen, nicht dünnwandigen ersten Hartkomponente. Die erste Hartkomponente wird mittels Spritzguss in einem Werkzeug ausgeformt und besteht nicht aus einem geformten folienförmigen Material. Die erste Hartkomponente verfügt somit vorzugsweise über sehr unterschiedliche Wandstärken. Dies insbesondere im Gegensatz zum aus WO 2001/096088 und der EP 1 289 729 B1 bekannten Verfahren, wo an eine vorgefertigte Schale aus flächenförmigem Material Kunststoff überspritzt wird.

Die vorliegende Erfindung erlaubt es, die erste Hartkomponente vollständig mit dem metallischen Überzug zu versehen und trotzdem im betreffenden Teil der Zahnbürste eine Oberfläche zu erreichen, die nicht nur metallisch ist. Folglich kann bei der Herstellung des metallischen Überzugs auf ein aufwändiges Abdecken von Bereichen der Hartkomponente verzichtet werden. Überdies kann auch auf ein solches Abdecken verzichtet werden, wenn die erste Hartkomponente - nicht erfindungsgemäss - nur partiell mit einem metallischen Überzug zu versehen ist. Eine scharfe und genaue Grenze des metallischen Überzugs ist nicht notwendig, da der Grenzbereich des metallischen Überzugs von der zweiten Hartkomponente überdeckt sein kann.

Die zweite Hartkomponente kann aus demselben Kunststoffmaterial bestehen wie die mit dem metallischen Überzug versehene erste Materialkomponente.

Da die erste Hartkomponente im Griffteil einen wesentlichen Anteil am Querschnitt des Griffteils einnimmt - siehe dazu auch Anspruch 2 - kann die mit dem metallischen Überzug versehene erste Hartkomponente eine tragende Funktion übernehmen und eine zuverlässige Herstellung, insbesondere mittels Mehrkomponentenspritzguss, ermöglichen. Die erste Hartkomponente wird üblicherweise im Spritzgussverfahren, insbesondere mittels Mehrkomponentenspritzguss, hergestellt. Dadurch kann die erste Hartkomponente eine Formtrennlinie aufweisen, die gemäss Anspruch 3 metallische überzogen ist. Neben funktionalen Eigenschaften kann damit auch ein gewünschter optischer Effekt erzielt werden.

In üblichen Herstellungsprozessen, beispielsweise mittels Mehrkomponentenspritzgussverfahren, kann an eine erste Hartkomponente eine weitere Kunststoffkomponente direkt an- oder überspritzt werden, so dass diese beiden Komponenten aneinanderhaften, d.h. miteinander eine Verbindung eingehen und einen Materialschluss bilden. Diese Fähigkeit, während dem Mehrkomponentenspritzguss eine Haftung oder Verbindung einzugehen, kann durch den metallischen Überzug der ersten Hartkomponente, trotz kompatiblen Materialien, verloren gehen. Der metallische Überzug wirkt sozusagen als Trennschicht zwischen der ersten Hartkomponente und der weiteren Kunststoffkomponente.

Dieses Problem kann in nicht der Erfindung entsprechender Weise dadurch gelöst werden, dass die erste Hartkomponente nur bereichsweise mit einem metallischen Überzug versehen ist und eine zweite Hart- oder eine Weichkomponente, welche den metallischen Überzug wenigstens bereichsweise überdeckt, in der überzugsfreien Zone mit der ersten Hartkomponente durch beim Mehrkomponentenspritzguss erzeugte Haftung verbunden ist. Die mit der metallischen Schicht überzogene erste Hartkomponente, sowie die weiteren Kunststoffkomponenten bestehen in diesem Fall vorzugsweise aus affinen oder kompatiblen Materialien.

Das oben genannte Problem kann jedoch gemäss Anspruch 4 auch so gelöst werden, dass die zweite Hartkomponente wenigstens eine Zone aufweist, die bezüglich der ersten Hartkomponente frei liegt, und eine weitere Komponente angespritzt wird, welche in der freiliegenden Zone einen Materialschluss mit der zweiten Hartkomponente eingeht. Eine an die zweite Hartkomponente angespritzte weiche Komponente kann zu einer besonders guten Haptik führen, indem die weiche Komponente insbesondere an jenen Orten vorgesehen wird, welche für das Halten der Zahnbürste mit der Hand wichtig sind, wie beispielsweise im Bereich, wo der Handballen und der Daumen aufliegen.

Um das oben genannte Problem der mangelnden Haftung zu überwinden, ist gemäss Anspruch 5 die zweite Hartkomponente mechanisch, form- und/oder kraftschlüssig, beispielsweise mittels einer Schwundverbindung, mit der Hartkomponente fest verbunden. Derartige Schwundverbindungen von nicht kompatiblen Hartmaterialien sind beispielsweise aus der WO 00/34022 A1 bekannt.

In einer bevorzugten Ausführungsform der Zahnbürste liegt gemäss Anspruch 6 die weiche Komponente wenigstens bereichsweise direkt am metallischen Überzug an. Einerseits ist zwischen der weichen Komponente und der zweiten Hartkomponente eine sehr gute Haftung erzielbar und andererseits kann die weiche Komponente über die zweite Hartkomponente hinaus vorstehen und damit direkt am metallischen Überzug anliegen, ohne dass die Gefahr des Ablösens der weichen Komponente besteht. Dies insbesondere, wenn das Vorstehen der weichen Komponente über die zweite Hartkomponente nicht allzu gross gewählt wird, beziehungsweise nur im Randbereich der Hartkomponente stattfindet.

Besonders bevorzugte Verankerungsmöglichkeiten für die zweite Hartkomponente an der metallisch überzogenen ersten Hartkomponente sind im Patentanspruch 7 definiert.

Eine besonders stabile Verankerung der zweiten Hartkomponente ist in den Patentansprüchen 8 und 9 angegeben.

Eine weitere besonders bevorzugte Ausbildung der Befestigung der zweiten Hartkomponente definiert Anspruch 10.

Die besonders bevorzugte Ausführungsform der Zahnbürste gemäss Anspruch 11 verhindert das Eindringen von Flüssigkeit, insbesondere Wasser, zwischen der zweiten Hartkomponente und der ersten Hartkomponente bzw. deren metallischen Überzug. Einerseits ist es dadurch möglich, erfindungsgemässe Zahnbürsten auch als Elektrozahnbürsten auszubilden und andererseits kann die Gefahr der Keimbildung reduziert werden.

Der Anspruch 11 gibt besonders bevorzugte Verfahren zum Herstellen des metallischen Überzugs an.

Um die weiter oben dargelegten Probleme der Haftung des metallischen Überzugs an der ersten Hartkomponente zu lösen, sind die erfindungsgemässen Zahnbürsten in bevorzugterweise gemäss Anspruch 13 ausgebildet.

Bei besonders bevorzugten Zahnbürsten gemäss Anspruch 14 ist die Haftung zwischen dem metallischen Überzug und der zweiten Hartkomponente bzw. der Weichkomponente verbessert.

Besonders geeignete Kunststoffe für die erste Hartkomponente und für die zweite Hartkomponente sind im Patentanspruch 15 bzw. 16 angegeben.

Zur Verbesserung der Haftung der zweiten Hartkomponente bzw. der weichen Komponente mit dem metallischen Überzug wird in bevorzugter Weise gemäss Anspruch 17 Haftvermittler verwendet.

Besonders geeignete Haftvermittler sind in Anspruch 18 angegeben.

Ein besonders bevorzugter Querschnitt der Zahnbürste ist im Patentanspruch 19 angegeben.

Der Anspruch 21 definiert ein Verfahren zum Herstellen erfindungsgemässer Zahnbürsten.

Das erfindungsgemässe Verfahren zum Herstellen der Zahnbürsten kann, wie in Anspruch 22 angegeben, inline oder gemäss Anspruch 23 offline durchgeführt werden.

Eine besonders bevorzugte Ausführungsform des erfindungsgemässen Verfahrens ist in Anspruch 24 angegeben. Es ermöglicht, auf einfache Art und Weise die Herstellung von erfindungsgemässen Zahnbürsten mit einer besonders guten Haptik.

Die Erfindung wird anhand in der Zeichnung dargestellter Ausführungsformen näher erläutert. Es zeigen rein schematisch:
- Fig. 1: in Ansicht eine aus Kunststoff hergestellte erste Hartkomponente, welche in der fertigen Zahnbürste einen wesentlichen Teil des Griffteils bildet;
- Fig. 2: in Draufsicht die erste Hartkomponente gemäss Figur 1;
- Fig. 3: in Ansicht die vollständig metallisch überzogene erste Hartkomponente;
- Fig. 4: in Draufsicht die vollständig metallisch überzogene erste Hartkomponente gemäss Figur 3;
- Fig. 5: in Ansicht die mit dem metallischen Überzug versehene erste Hartkomponente und einer daran angespritzten zweiten Hartkomponente, welche auch den tragenden Teil des Halsteils sowie den Kopfteil der Zahnbürste bildet;
- Fig. 6: in Draufsicht die mit dem metallischen Überzug versehene erste Hartkomponente und die daran angespritzte zweite Hartkomponente gemäss Figur 5;
- Fig. 7: in Untersicht die mit dem metallischen Überzug versehene erste Hartkomponente und die daran angespritzte zweite Hartkomponente gemäss Figur 5 und 6;
- Fig. 8: in Ansicht die mit dem metallischen Überzug versehene erste Hartkomponente sowie die daran angespritzte zweite Hartkomponente, welche im Griffteil und im Halsteil mit einer weichen Komponente überspritzt ist; Figur 8 zeigt somit den fertigen unbeborsteten Zahnbürstenkörper, wobei eine Beborstung im Kopfteil angedeutet ist;
- Fig. 9: in Draufsicht den Zahnbürstenkörper gemäss Figur 8;
- Fig. 10: in Ansicht eine der Figur 8 sehr ähnliche Ausführungsform des Zahnbürstenkörpers, bei welcher die zweite Hartkomponente, die mit dem metallischen Überzug versehene erste Hartkomponente in Umfangsrichtung mit Hilfe eines bandartigen Stegs vollständig umgreift;
- Fig. 11: in Draufsicht den Zahnbürstenkörper gemäss Figur 10;
- Fig. 12: in Ansicht eine den Ausführungsformen gemäss Figuren 8 - 11 sehr ähnliche Ausführungsform, wobei jedoch die weiche Komponente mittels eines Weichkomponentenstegs in Umfangsrichtung sowohl die mit dem metallischen Überzug versehene erste Hartkomponente als auch zweite Hartkomponente vollständig umgreift;
- Fig. 13: in Draufsicht den Zahnbürstenkörper gemäss Figur 12
- Fig. 14: in Draufsicht einen Ausschnitt der mit dem metallischen Überzug versehenen ersten Hartkomponente mit zwei Öffnungen, die über einen Tunnel in der ersten Hartkomponente miteinander verbunden sind;
- Fig. 15: in einem Schnitt entlang der Linie XV-XV der Figur 14 einen Abschnitt der mit dem metallischen Überzug versehenen ersten Hartkomponente und dem Tunnel;
- Fig. 16: in Draufsicht den in den Figuren 14 und 15 gezeigten Teil mit einer in den Tunnel eingespritzten weiteren Kunststoffkomponente, welche die beiden Öffnungen überdeckt und zusammen mit dem weiteren Kunststoff im Tunnel einen geschlossenen Ring bildet;
- Fig. 17: in einem Schnitt entlang der Linie XVII-VXII der Figur 16 den betreffenden Ausschnitt der ersten Hartkomponente mit der weiteren Kunststoffkomponente, welche einen in sich geschlossenen Ring bildet;
- Fig. 18: in schematischer Darstellung drei Verfahrensschritte bei der Herstellung einer erfindungsgemässen Zahnbürste;
- Fig. 19 - 26: unterschiedliche mögliche Querschnitte durch den Griffteil erfindungsgemässer Zahnbürsten;
- Fig. 27: a) in Draufsicht und b) in einem Schnitt einen Teil einer partiell nicht erfindungsgemäß mit einem metallischen Überzug versehenen ersten Hartkomponente und c) in Draufsicht sowie d) im Schnitt die erste Hartkomponente mit einer daran angespritzten weiteren Kunststoffkomponente;
- Fig. 28: in schematischer Darstellung der Aufbau erfindungsgemässer Zahnbürsten;
- Fig. 29: in schematischer Darstellung die Verfahrensschritte zur Herstellung einer erfindungsgemässen Zahnbürste;
- Fig. 30: ein Layout einer Anlage zum Herstellen von erfindungsgemässen Zahnbürsten mit einem Rundlauf;
- Fig. 31: ein weiteres mögliches Layout für eine entsprechende Anlage; und
- Fig. 32: ein drittes mögliches Layout für eine entsprechende Anlage, ergänzt, in der Mitte, mit dem schematischen Prozessablauf und oben mit dem in jeweiligem Schritt erzeugten Produkt.

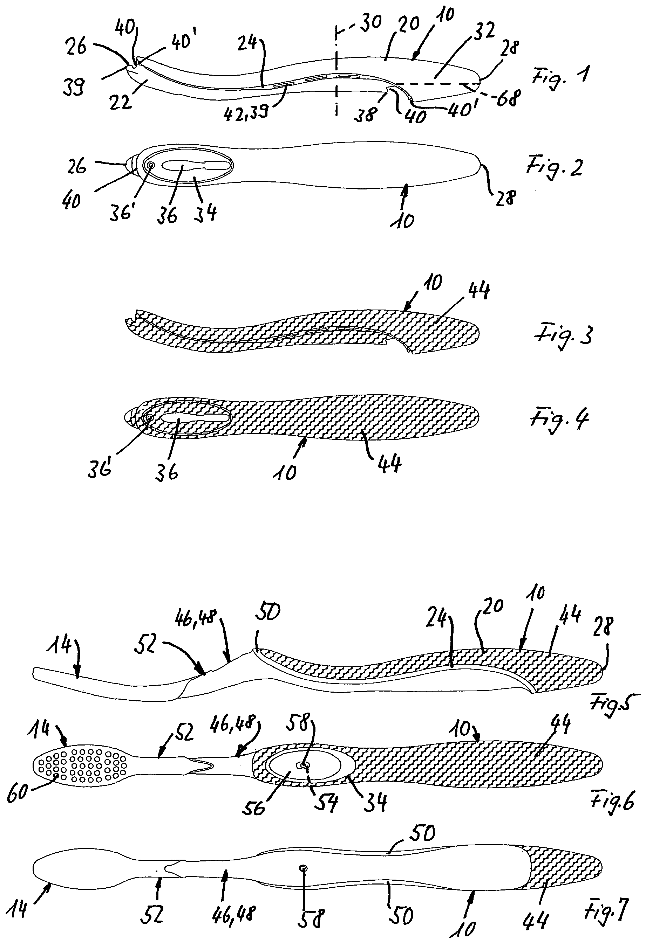

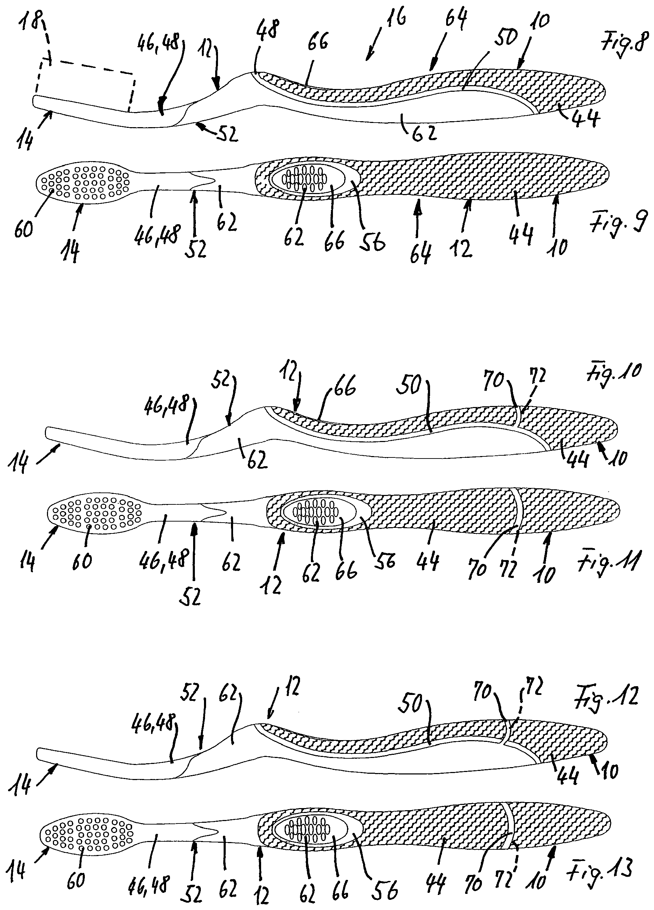

Die Figuren 1 und 2 zeigen in Ansicht bzw. Draufsicht eine erste Hartkomponente 10 für einen Zahnbürstenkörper 12, wie er in den Figuren 8 und 9 gezeigt ist. Der Zahnbürstenkörper 12 wird in seinem Kopfteil 14 zu einer vollständigen Zahnbürste 16 in bekannter Art und Weise mit Borsten 18 versehen.

Die erste Hartkomponente 10 wird in einer ersten Kavität eines Mehrkomponentenspritzgusswerkzeugs oder in einer Kavität eines Einkomponentenwerkzeuges aus einem harten Kunststoff hergestellt. Die folgende Formgebung ist nur beispielhaft, selbstverständlich sind auch ähnliche oder andere Formen denkbar.

In Ansicht weist die erste Hartkomponente 10 eine schwache S-Form auf und zwischen einem Oberteil 20 und einem Unterteil 22 der einstückigen ersten Hartkomponente 10 verläuft eine Schulter 24. Die Schulter 24 verläuft von einem vorderen Ende 26 der ersten Hartkomponente 10, in Ansicht, S-förmig seitlich der ersten Hartkomponente 10 in Richtung gegen hinten und unten, so dass ein hinteres Ende 28 der ersten Hartkomponente von der Schulter 24 beabstandet ist. In rechtwinklig zur Längsrichtung der ersten Hartkomponente 10 verlaufenden Querschnitten 30 ist die Oberfläche 32 des Oberteils 20 annähernd halbkreisförmig und in dem Bereich zwischen dem hinten liegenden Ende der Schulter 24 und dem hinteren Ende 28 annähernd kreisförmig. In Folge der Schulter 24 ist der Unterteil 22 gegenüber dem Oberteil 20, in radialer Richtung, gegen innen zurückversetzt. Der Oberteil 20 weist im Bereich einer späteren Daumenauflage eine in Draufsicht gesehen ovale Vertiefung 34 auf, von welcher eine im Querschnitt längliche erste Verankerungsausnehmung 36 und eine im Querschnitt runde zweite Verankerungsausnehmung 36' durch die erste Hartkomponente 10 hindurch geht. Selbstverständlich können Lage und Richtung der Verankerungsausnehmungen 36, 36' je nach Formgebung der ersten Hartkomponente variieren.

Beispielsweise können Verankerungsausnehmungen seitlich oder schräg die erste Hartkomponente durchdringen. Der Unterteil 22 weist von seinem hinteren Ende 38 bis zur ersten Verankerungsausnehmung 36 einen etwa dreieckförmigen Querschnitt auf. Er geht dann seitlich der ersten Verankerungsausnehmung 36 in einen annähernd rechteckigen Querschnitt zwischen dem vorderen Ende der ersten Verankerungsausnehmung 36 und dem vorderen Ende 26 der Hartkomponente 10 über. Durch diesen im Querschnitt rechteckigen Teil hindurch verläuft die zweite Verankerungsausnehmung 36'.

Der Unterteil 22 ist bei seinem vorderen Ende mit einem Verankerungsvorsprung 39 sowie beim hinteren Ende 38 und vorderen Ende 26 mit je einer Hinterschneidung 40 versehen. Weiter bildet die Schulter 24 in ihrem vorne liegenden Endbereich und in ihrem hinten liegenden Endbereich je eine weitere Hinterschneidung 40'. Weiter weist der Unterteil 22 auf seinen beiden Seiten, in einem Abstand zur Schulter 24, drei in Längsrichtung hintereinander angeordnete, seitlich vorstehende Wulste 42 auf, welche wiederum Verankerungsvorsprünge 39 bilden. Bei alternativen Formgebungen der ersten Hartkomponente können diese Verankerungsvorsprünge und/oder Hinterschneidungen auch an anderen Orten platziert werden. Vorzugsweise sind diese im Randbereich der ersten Hartkomponente - und einer zweiten Hartkomponente - platziert, dass eine erwünschte Schwundverbindung bereits möglichst im Randbereich der Hartkomponenten greift.

Die erste Hartkomponente 10 wird in einem zweiten Verfahrensschritt in dieser Ausgestaltungsvariante vollständig mit einem metallischen Überzug 44 versehen. Dies insbesondere, wenn mit galvanischen Verfahren mittels Tauchbädern gearbeitet wird. Wie dies in den Figuren 3 und 4 mit der Schraffur "Thermal Insulation" angedeutet ist. Der metallische Überzug 44 ist auch in den weiteren Figuren mit dieser Schraffur hervorgehoben.

Falls mittels CVD (Chemical Vapor Deposition), PVD (Physical Vapor Deposition) oder Sputtern gearbeitet wird, ist es durch Maskierung möglich, den metallischen Überzug 44 nur bereichsweise oder einseitig aufzubringen. In diesem Fall können alternativ nur jene Teilbereiche der Oberflächen der ersten Hartkomponente 10, welche von einer zweiten Hartkomponente überdeckt wird, metallisch beschichtet sein.

In einem dritten Verfahrensschritt wird die mit dem metallischen Überzug 44 versehene erste Hartkomponente 10 in eine zweite Kavität des Mehrkomponentenspritzgusswerkzeugs - oder in die erste Kavität eines weiteren separat betrieben Werkzeuges - eingesetzt, derart, dass mindestens ein Teil der Oberfläche, in diesem Fall der Oberteil 20 an der Kavitätenwand anliegt.

In einer nicht erfindungsgemässen Ausbildungsform kann der an die Kavität anliegende Oberflächenanteil der mit einem mindestens teilweise metallischen Überzug 44 versehenen ersten Hartkomponente 10 jedoch auch ein unbeschichteter Oberflächenanteil der ersten Hartkomponente 10 sein.

Eine weitere Kunststoffkomponente 46, im vorliegenden Fall ein weiterer harter Kunststoff, wird in die zweite Kavität eingespritzt, um so eine zweite Hartkomponente 48 zu erzeugen. Diese umschliesst oder überdeckt mindestens ein Teil der ersten Hartkomponente 10 - in diesem Fall den Unterteil 22 der ersten Hartkomponente - vollständig und bildet einen bandförmigen Wulst 50 entlang der Schulter 24, wobei die aussen liegende Oberfläche dieses bandförmigen Wulstes 50 mit der Oberfläche 32 des Oberteils 20 fluchtet. Die zweite Hartkomponente 48 ist mit den Verankerungsvorsprüngen 39, Hinterschneidungen 40, weiteren Hinterschneidungen 40' und Wulsten 42 in Formschluss und in Folge des Schwundverhaltens des harten Kunststoffs beim Abkühlen und Aushärten auch mit der mit dem metallischen Überzug 44 versehenen ersten Hartkomponente 10 in einen Kraftschluss getreten. Die erste Hartkomponente 10 und die zweite Hartkomponente 48 sind somit - ohne Beildung eines Materialschlusses - ausschliesslich auf mechanische Art und Weise miteinander unlösbar fest verbunden; siehe dazu Figuren 5, 6 und 7. Diese mechanische feste Verbindung wird besonders bevorzugt eingesetzt, da unabhängig von der Materialkompatibilität und der Grösse des metallischen Überzugs 44 zwischen den Hartkomponenten 10 und 48 eine sichere Verankerung erzeugt werden kann. Dies im Gegensatz zum Stand der Technik, bei welchem ein Materialschluss vorausgesetzt wird.

Die zweite Hartkomponente 48 bildet den tragenden Teil eines Halsteils 52 des Zahnbürstenkörpers 12 als auch deren Kopfteil 14. Weiter durchgreift die zweite Hartkomponente 48 mittels Materialbrücken 54 die erste und die zweite Verankerungsausnehmung 36, 36' und bildet in der Vertiefung 34 einen flächigen Belag 56. Durch die die erste Verankerungsausnehmung 36 durchdringende Materialbrücke 54 hindurch bleibt ein Durchlass 58 frei. Auch durch die Materialbrücken 54 ist der flächige Belag 56 unlösbar fixiert und liegt in Folge des Schwundverhaltens spaltlos und wasserdicht am metallischen Überzug 44 an.

In Figur 6 sind im Kopfteil 14 die in Richtung gegen die Oberseite der Zahnbürste 16 hin offenen, sacklochartigen Borstenbündelaufnahmelöcher 60 gezeigt. Selbstverständlich kann die Beborstung auch mittels anderen Verfahren erzeugt werden, wie beispielsweise mittels den in der Branche bekannten Verfahren AFT (Anchor Free Tuffing) oder IMT (In Mould Tuffing. Sinnvollerweise wird bei den Verfahren, bei denen Borsten oder Borstenträger mittels Einspritzen von Kunststoffen am Zahnbürstengriff fixiert werden, das Überspritzen der mit dem metallischen Überzug 44 versehenen ersten Hartkomponente im gleichen Arbeitsgang und mit der gleichen Kunststoffkomponente wie die Borsten- oder Borstenträgerfixierung vollzogen.

Der soweit gemäss den Figuren 5 bis 7 hergestellte Formling wird dann in eine weitere Kavität des Mehrkomponentenspritzgusswerkzeugs - oder in ein weiteres Einkomponentenwerkzeug - umgelegt, in welche dann ein weicher Kunststoff zur Bildung einer weichen Komponente 62 eingespritzt wird; siehe Fig. 8 und 9. Die weiche Komponente 62 geht mit der zweiten Hartkomponente 48, infolge der Verwendung von affinen, d.h. kompatiblen Kunststoffen, eine Haftung - im vorliegenden Zusammenhang auch Materialschluss genannt - ein und überdeckt im Griffteil 64 die zweite Hartkomponente 48 vollständig, mit Ausnahme der Aussenfläche des bandförmigen Wulstes 50, und umschliesst die zweite Hartkomponente 48 im Halsteil 52 zwischen dem Griffteil 64 und etwa der Mitte des Halsteils 52. Überdies ist der weiche Kunststoff durch den Durchlass 58 hindurch auf die Oberseite des Zahnbürstenkörpers 12 geflossen, ist dort mit dem flächigen Belag 56 bestehend aus der zweiten Hartkomponente 48 eine Haftung - einen Materialschluss - eingegangen und bildet eine mit Noppen versehene Daumenauflage 66.

Der fertig gestellte Zahnbürstenkörper 12, wie er in den Figuren 8 und 9 gezeigt ist, wird dem Spritzgusswerkzeug entnommen und je nach Beborstungsverfahren noch einer Stopfstation zugeführt. Die Borsten 18 sind in Fig. 8 schematisch angedeutet.

Bei der ersten Hartkomponente 10 verläuft die Formtrennlinie 68 entlang der Schulter 24 bis nahezu zu deren hinteren Ende 38 und von dort entlang der gestrichelt angedeuteten Linie 68; vergleiche Fig. 1. Der metallische Überzug 44 verläuft ununterbrochen über die Formtrennlinie 68 hinweg.

Der Zahnbürstenkörper 12 zu einer zweiten Ausführungsform einer erfindungsgemässen Zahnbürste ist, dargestellt in Fig. 10 und 11, mit der Ausnahme eines Steges 70 genau gleich ausgebildet und nach dem gleichen Verfahren hergestellt, wie weiter oben im Zusammenhang mit den Figuren 1 bis 9 beschrieben. Der Steg 70 besteht aus der zweiten Hartkomponente 48 und verbindet den umlaufenden bandförmigen Wulst 50 durch eine mit dem metallischen Überzug 44 versehene entsprechende Nut 72 des Oberteils 20 hindurch, derart, dass in einem Querschnitt nahe beim hinteren Ende der zweiten Hartkomponente 48 diese die erste Hartkomponente 10 mit dem metallischen Überzug 44 in Umfangsrichtung vollständig umschliesst. Dieser Steg 70 kann natürlich in Form, Lage und Anzahl je nach Ausführungsform variieren. Zusätzlich kann der Steg, analog dem vorher besprochenen Verfahren, auch mindestens teilweise mit der der zweiten Hartkomponente 48 haftenden weichen Komponente 62 bedeckt sein.

Die in den Figuren 12 und 13 gezeigte Ausführungsform des Zahnbürstenkörpers 12 entspricht jener gemäss den Figuren 10 und 11, wobei nun jedoch der Steg 70 nur von der weichen Komponente 62 gebildet ist. Zu diesem Zweck ist der bandförmige Wulst 50 in Verlängerung der Nut 72, wenigstens partiell oder mindestens oberflächlich, unterbrochen, so dass beim Spritzgiessen der weiche Kunststoff in die Nut 72 hinein fliessen kann. Da die weiche Komponente 62 mit der metallischen Beschichtung der ersten Hartkomponente 10, ohne weiteres Zutun, keine Verbindung eingeht, wird die weiche Komponente 62 vorzugsweise in die Oberfläche der metallisch beschichteten ersten Hartkomponente 10 eingelassen. Dies verhindert ein partielles Ablösen der weichen Komponente 62.

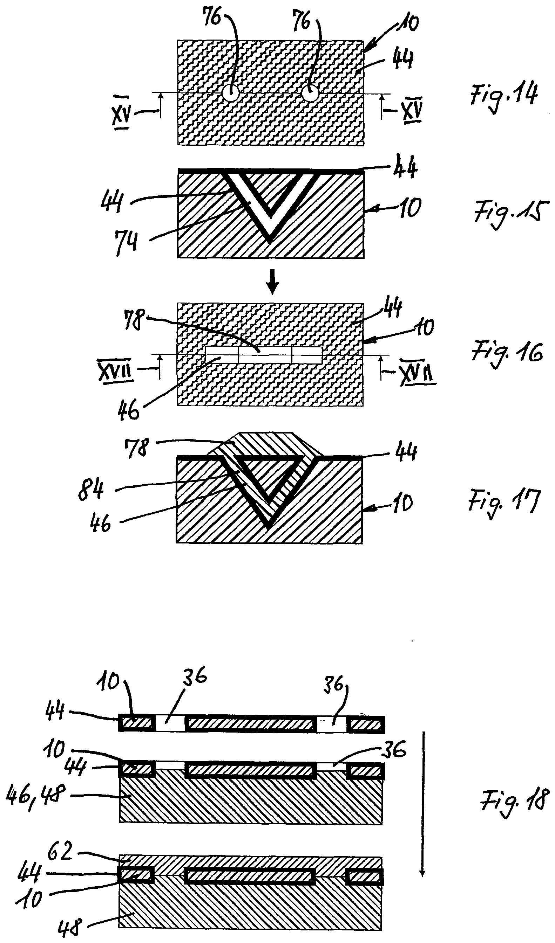

Die Figuren 14 bis 17 zeigen eine weitere Möglichkeit zur Befestigung, beispielsweise einer Daumenauflage 66 oder anderer Bereiche gebildet aus weiteren Komponenten 46, an der mit dem metallischen Überzug 44 versehenen ersten Hartkomponente 10. Diese weist als Verankerungsausnehmung einen Tunnel 74 auf, welcher im Schnitt gesehen V-förmig oder zumindest im Spritzgusswerkzeug entformbar ausgebildet ist und bei Öffnungen 76 an die Oberfläche mündet. Da die erste Hartkomponente 10 vom metallischen Überzug 44 überdeckt ist, ist auch die Wand des im innern der Hartkomponente verlaufenden Tunnels 74 durch den metallischen Überzug 44 gebildet. In den Tunnel 74 wird zur Bildung einer weiteren Kunststoffkomponente 46 ein weicher oder ein harter Kunststoff eingespritzt, welcher auf dem metallischen Überzug 44 eine äussere Brücke 78 bildet. Die weitere Kunststoffkomponente 46 bildet somit innerhalb der ersten Hartkomponente 10 einen dreieckförmigen in sich geschlossenen Ring, wodurch dieser fest an der ersten Hartkomponente 10 verankert ist. Alternativ zur beispielhaften V-förmigen Ausbildung können selbstverständlich auch andersförmige mit der Oberfläche wirkverbundene und geschlossene Materialbrücken gebildet werden. In Folge des Schwundverhaltens der weiteren Kunststoffkomponente liegt die, beispielsweise eine Daumenauflage bildende Brücke 78, satt an dem metallischen Überzug 44 an. Weiter kann die Brücke 78 eine Insel bilden, welche vom metallischen Überzug 44 umgeben ist. Es ist aber auch möglich, dass die Verankerung für Formen verwendet wird, in welchen die Materialien zungenartig auf der metallischen Oberfläche aufgebracht sind.

Figur 18 zeigt schematisch eine weitere Möglichkeit zum Fixieren einer zweiten Hartkomponente 48 und einer weichen Komponente 62 in einer mit einem metallischen Überzug 44 versehenen ersten Hartkomponente 10. Wie der obersten Darstellung in Figur 18 zu entnehmen ist, weist die erste Hartkomponente 10 zwei durchgehende Verankerungsausnehmungen 36 in Form von Durchlässen auf. Die erste Hartkomponente 10 ist metallisch überzogen.

Wie in der mittleren Darstellung angedeutet, wird auf der einen Seite der mit dem metallischen Überzug 44 versehenen ersten Hartkomponente 10 die weitere Kunststoffkomponente 46, im vorliegenden Fall eine zweite Hartkomponente 48, angespritzt. Diese reicht bis etwa mittig in die Verankerungsausnehmungen 36 hinein. Diese Verankerungsausnehmung 36 kann so gestaltet werden, dass sich die zweite Hartkomponente 48 an ihr mechanisch verankert, beispielsweise kann sie im Querschnitt trapezförmig angelegt sein, wobei sich die Ausnehmung trichterartig gegen die weitere Weichkomponente 62 öffnet. Anschliessend wird, wie dies die unterste Abbildung von Figur 18 zeigt, auf der anderen Seite der ersten Hartkomponente 10 eine dritte Kunststoffkomponente, im vorliegenden Fall eine weiche Komponente 62, im Mehrkomponentenspritzgussverfahren angespritzt. Diese weiche Komponente 62 geht, auf Grund der Affinität der beiden Kunststoffe, in der Verankerungsausnehmung 36 mit der zweiten Hartkomponente 48 eine stabile Haftung, einen Materialschluss, ein. Es ist aber auch möglich, dass eine weitere Hartkomponente die dritte Kunststoffkomponente darstellt.

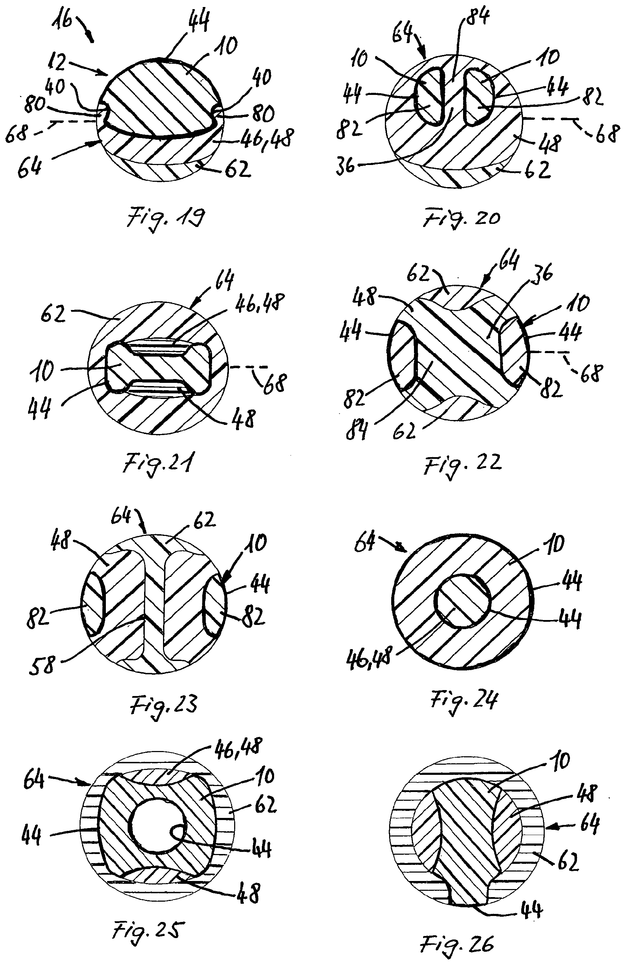

Figur 19 zeigt einen Querschnitt durch den Griffteil 64 des Zahnbürstenkörpers 12 einer Zahnbürste 16, die über sehr ähnliche Querschnitte verfügt, wie die in den Figuren 8 und 9 gezeigte Zahnbürste. Die erste Hartkomponente 10 ist im Querschnitt vollständig, mit einem metallischen Überzug 44 versehen (dicker Strich im Randbereich). Sie weist einen voluminösen, in diesem Beispiel nahezu halbkreisförmigen Querschnitt auf, wobei im Übergangsbereich von der schwach gekrümmten Basis zum kreiszylinderförmigen Mantel in Längsrichtung der Zahnbürste verlaufende, nutenartige Hinterschneidungen 40 vorgesehen sind. Alternativ können natürlich auch in Fig. 1 gezeigte Verankerungsvorsprünge vorgesehen werden. Im Bereich des genannten Mantels ist der metallische Überzug 44 in dieser Ausführungsform sichtbar und tritt an die Oberfläche der Zahnbürste. In einer nicht erfindungsgemässen Ausführungsform kann der metallische Überzug 44 nur in einem Bereich der gemeinsamen Oberfläche zwischen der ersten Hartkomponente 10 und der zweiten Hartkomponente 48 auf der ersten Hartkomponente 10 aufgetragen sein. Im Bereich der Basis und der Hinterschneidungen 40 ist an die erste Hartkomponente 10 die zweite Hartkomponente 48 um- oder angespritzt. Diese greift mit einer wandartigen Lippe 80 in die Hinterschneidungen 40 ein und bildet in Folge der Geometrie der Anordnung und ihres Schwundverhaltens eine feste mechanische, form- und kraftschlüssige Verbindung mit der ersten Hartkomponente 10. Die unten liegende Oberfläche der zweiten Hartkomponente 48 verläuft etwa parallel zur Basis der ersten Hartkomponente 10. Die zweite Hartkomponente 48 kann transparent oder transluszent sein, damit der metallische Überzug 44 durch die zweite Hartkomponente 48 hindurch sichtbar bleibt.

An die Oberfläche der zweiten Hartkomponente 48 ist, ebenfalls im Mehrkomponentenspritzgussverfahren, eine weiche Komponente 62 angespritzt. Da affine, d.h. sich verbindende, kompatible Materialien verwendet werden, geht diese weiche Komponente 62 mit der zweiten Hartkomponente 48 eine Haftung, einen Materialschluss, ein. Im gezeigten Querschnitt weist der Zahnbürstenkörper 12 beispielhaft nahezu eine Kreisform auf. Der Querschnitt kann selbstverständlich bei allen Beispielen eine elliptische oder andere rundliche Form einnehmen.

Die Flächenaufteilung des Querschnitts in dieser oder auch anderen Figuren sind selbstverständlich nur beispielhaft. Flächenform und Flächenaufteilung der Komponenten, sowie äussere Form des Querschnittes bezw. der Zahnbürste können unterschiedlich ausfallen ohne den Umfang der Erfindung zu verlassen, vorzugsweise bleibt der Aufbau des Querschnittes beibehalten.

Es wird auch ausdrücklich betont, dass sich der Querschnitt nur in einzelnen Bereichen der Zahnbürste entsprechend den Figuren verhält. Querschnitte in anderen Bereichen der Zahnbürste können selbstverständlich anders aussehen. Es ist auch möglich, einzelne Eigenschaften oder Kombinationen oder Flächenaufteilungen der Komponenten von einzelnen gezeigten Querschnitten mit anderen gezeigten Querschnitten zu kombinieren. Die einzelnen Querschnitte können auch in Ihrer Lage bzw. Orientierung gedreht werden, ohne den Umfang dieser Erfindung zu verlassen.

Die weiche Komponente 62 ist wenigstens partiell nur mit der zweiten Hartkomponente 48 in Berührung und nur diese ist mit dem metallischen Überzug 44 der ersten Hartkomponente 10 in Berührung.

Es ist auch denkbar, die Basis der ersten Hartkomponente 10 über die Formtrennlinie 68 hinaus weiter in die zweite Hartkomponente 48 hineinragen zu lassen, so dass sie näher bei der weichen Komponente 62 endet. Im in der Figur 19 gezeigten Querschnitt nimmt die erste Hartkomponente 10 einen wesentlichen Anteil, beispielhaft etwa die Hälfte der gesamten Querschnittsfläche ein.

Im in der Figur 20 gezeigten Querschnitt durch den Griffbereich einer Zahnbürste 16 reicht der metallische Überzug 44 der ersten Hartkomponente 10 nicht an die aussen liegende Oberfläche des Griffbereichs. Die erste Hartkomponente 10 weist in diesem Schnitt zwei in Längsrichtung der Zahnbürste verlaufende parallele Arme auf, die zu einer Längsmittelebene symmetrisch und im Querschnitt annähernd halbkreiszylinderförmig ausgebildet sind. Wiederum sind Form, Position und die Anzahl der Arme beispielhaft gezeichnet und können von der Figur abweichen, ohne den Umfang der Erfindung zu verlassen. Die beiden metallisch überzogenen Arme 82 sind vollständig von der zweiten Hartkomponente 48 umschlossen. Im Bereich zwischen den beiden Armen 82 bildet somit die zweite Hartkomponente 48 eine Materialbrücke 84; die beiden Arme 82 begrenzen eine durchgehende Verankerungsausnehmung 36. Vorzugsweise wird auch in diesem Fall eine transluszente oder transparente zweite Hartkomponente 48 eingesetzt.

An einem unten liegenden Oberflächenbereich der zweiten Hartkomponente 48 ist im Querschnitt beispielhaft mondsichelartig eine weiche Komponente 62 angespritzt. In Folge der Verwendung von affinen Materialien im Mehrkomponentenspritzgussverfahren haftet die weiche Komponente 62 an der weiteren Hartkomponente 48. Die weiche Komponente 62 berührt den metallischen Überzug 44 nicht. Der Querschnitt des Griffteils 64 ist wiederum beispielhaft nur kreisförmig gezeichnet. Die beiden Arme 82 der ersten Hartkomponente 10 nehmen im gezeigten Querschnitt ca. 20 % der gesamten Querschnittsfläche ein. Je nach Lage des Querschnittes kann dieser Anteil auch wesentlich höher sein.

In axialer Richtung gesehen, in einem Abstand vom gezeigten Querschnitt, können sich die beiden Arme 82 vereinigen und bilden somit eine weiter oben beschriebene Verankerungsausnehmung 36. Selbstverständlich ist es auch möglich, Querschnitte mit drei oder mehr Armen zu bilden.

Bei einem weiteren möglichen, in der Figur 21 gezeigten Querschnitt durch den Griffteil 64 weist die erste Hartkomponente 10 beispielhaft einen H-förmigen Querschnitt auf und ist wiederum in Querschnitt vollständig, mit einem metallischen Überzug 44 versehen. In die beiden trogartigen, von der ersten Hartkomponente 10 gebildeten Räumen ist im Mehrkomponentenspritzgussverfahren die zweite Hartkomponente 48 eingespritzt. Die nachträglich ebenfalls im Mehrkomponentenspritzgussverfahren angespritzte weiche Komponente 62 umgibt vollständig die erste Hartkomponente 10 mit der zweiten Hartkomponente 48 und geht mit letzterer eine Haftung, einen Materialschluss, ein und berührt auf beiden Seiten den metallischen Überzug 44 im von der zweiten Hartkomponente 48 nicht überdeckten Bereich. Der Querschnitt des Griffteils 64 ist wieder beispielhaft kreisförmig und die erste Hartkomponente 10 nimmt in etwa 30 % der Querschnittsfläche ein. Die Formentrennung ist mit 68 angedeutet.

Um die beiden Teile der zweiten Hartkomponente 48 zusätzlich an der ersten Hartkomponente 10 zu befestigen, ist es möglich, in axialer Richtung vom gezeigten Querschnitt beabstandet, an der ersten Hartkomponente 10 Verankerungsausnehmungen oder Verankerungsvorsprünge auszubilden oder die beiden Teile mit einer Materialbrücke 84 analog Figur 20 miteinander zu verbinden. Wesentlich an diesem Querschnitt ist, dass die weiche Komponente 62 mindestens einen Teil der, mit der metallischen Schicht versehenen ersten Hartkomponente 10 umschliessen kann, indem die weiche Komponente 62 mittels Mehrkomponentenspritzguss in mindestens einem Querschnittbereich mit der zweiten Hartkomponente 48 eine Verbindung eingeht, ohne aber mit der mit dem metallischen Überzug 44 versehenen ersten Hartkomponente 10 einen Materialschluss einzugehen. In diesem Fall wird ebenfalls vorgeschlagen, eine transluszente oder transparente weiche Komponente 62 einzusetzen, um den metallischen Überzug 44 sehen zu können.

Bei einer weiteren im Querschnitt in Figur 22 gezeigten Ausführungsform weist die erste Hartkomponente 10 wiederum beispielhaft zwei Arme 82 auf, die zu einer Längsmittelebene symmetrisch ausgebildet sind und deren radial aussen liegende Oberfläche an der Peripherie des kreisförmigen Querschnitts des Griffteils 64 liegt. Die beiden Arme 82 sind voneinander beabstandet und sie sind ebenfalls im Querschnitt vollständig, mit dem metallischen Überzug 44 versehen. Auf beiden Seiten des Griffteils 64 der Zahnbürste ist somit im gezeigten Querschnitt der metallische Überzug 44 sichtbar. Die beiden Arme 82 begrenzen eine breite durchgehende Verankerungsausnehmung 36, die mittels Mehrkomponentenspritzguss mit der zweiten Hartkomponente 48 ausgefüllt ist. Im Bereich der Verankerungsausnehmung 36 bildet die zweite Hartkomponente 48 eine Materialbrücke 84, von deren oberen und unteren Ende beidseitig Stege abstehen, welche die Arme 82 bis zur Peripherie des Querschnitts umgreifen. Der Querschnitt der zweiten Hartkomponente 48 ist im Wesentlichen X-förmig. Lage, Anzahl und Form der Arme sind beispielhaft und können je nach Lage des Querschnittes ändern. Analog zu vorhergehenden Querschnitten können zur Verankerung der zweiten weiteren Hartkomponente an der ersten Hartkomponente 10 Verankerungsausnehmungen und/oder Verankerungsvorsprünge vorgesehen werden.

Oben und unten ist an die zweite Hartkomponente 48 eine weiche Komponente 62 mittels Mehrkomponentenspritzguss angebracht. In Folge der Verwendung von affinen Materialen haftet die weiche Komponente 62 an der zweiten Hartkomponente 48. Die Formtrennung ist mit 68 angedeutet. Anzahl und Position der Arme sowie deren Formgebung und Querschnittflächenanteil können in Längsrichtung wieder variieren. Alternativ kann die weiche Komponente 62 oben oder unten fehlen. An deren Stelle kann die zweite Hartkomponente 48 einen grösseren Teil des Querschnittes einnehmen.

Bei einem weiteren, in der Figur 23 gezeigten möglichen Querschnitt durch den Griffteil 64 weist die erste Hartkomponente 10 wiederum, analog der Ausführungsform gemäss Figur 22, zwei Arme 82 auf, welche in Querschnitt vollständig, von einem metallischen Überzug 44 überzogen sind, welcher auf den beiden Seiten des Querschnitts sichtbar ist. Ähnlich wie im Zusammenhang mit Figur 22 beschrieben, sind die beiden Arme 82 bis zur Peripherie des Querschnitts von der zweiten Hartkomponente 48 umgeben. Durch diese hindurch verläuft jedoch mittig von oben nach unten ein Durchlass 58. Dieser ist mittels Mehrkomponentenspritzguss mit einer weichen Komponente 62 gefüllt, welche im Querschnitt H-Form aufweist und die zweite Hartkomponente 48 teilweise umgreift. Von der Oberfläche her betrachtet verlaufen benachbart zum und oberhalb und unterhalb des metallischen Überzugs 44 Streifen der zweiten Hartkomponente 48, an welche oben und unten die weiche Komponente 62 anschliesst.

Beim in der Figur 24 gezeigten Querschnitt ist die erste Hartkomponente 10 beispielhaft kreisringförmig ausgebildet und wiederum mindestens teilweise, im gezeigten Querschnitt vollständig, innen und aussen, mit dem metallischen Überzug 44 versehen. Der von der ersten Hartkomponente 10 begrenzte Innenraum ist mit der zweiten Hartkomponente 48 oder der weichen Komponente 62 mindestens teilweise, im gezeigten Querschnitt vollständig, ausgefüllt. Die Verankerung der weiteren Kunststoffkomponente 46, d.h. der zweiten Hartkomponente oder der weichen Komponente 62, an der ersten Hartkomponente 10 erfolgt in einem anderen Querschnitt, beispielsweise mittels Verankerungsausnehmungen oder Verankerungsvorsprüngen.

Figur 25 zeigt einen Querschnitt durch den Griffteil 64 einer Zahnbürste 16, welcher in der vorliegenden Art insbesondere bei einer Elektrozahnbürste oder einem elektrischen Körperpflegeprodukt Anwendung finden kann. Die erste Hartkomponente 10 weist einen ringartigen Querschnitt auf, wobei die innen liegende Peripherie zum Beispiel kreisförmig und die aussen liegende Peripherie zum Beispiel nahezu quadratisch ist; jedoch sind die oben und unten liegenden Seiten konkav und die beiden anderen, einander gegenüberliegenden Seiten konvex ausgebildet. Form und Flächenanteil der ersten Hartkomponente 10 kann sich wiederum je nach Position des Querschnittes verändern. Die erste Hartkomponente 10 ist wiederum innen und/oder aussen, mit einem metallischen Überzug 44 versehen und der von ihr gebildete Hohlraum kann beispielsweise für die Aufnahme einer Batterie, eines Akkus oder anderen elektrischen Funktionskomponenten vorgesehen sein. Ähnlich der Ausführungsform gemäss Figur 21 ist der durch die konkave Form der ersten Hartkomponente 10 erzeugte oben und unten liegende Trog mit der zweiten Hartkomponente 48 aufgefüllt. Die Aussenkontur der ersten Hartkomponente 10 und der zweiten Hartkomponente 48 bilden in diesem Beispiel nahezu einen Kreis. Dieser ist vollständig von einer im Mehrkomponentenspritzgussverfahren aufgebrachten weichen Komponente 62 umgeben. Selbstverständlich könnte die Weichkomponente 62 auch nur einen Teil der Oberfläche bedecken.

Der Hohlraum in der ersten Hartkomponente 10 kann beispielsweise beim Mehrfachkomponentenspritzguss mittels eines Kerns geformt werden. Es ist jedoch auch denkbar, die erste Hartkomponente 10 in zwei Halbschalen herzustellen, welche den gemeinsamen Hohlraum bildend miteinander auf bekannte Art und Weise verbunden werden (Schweissen, Leimen, mittels Überspritzen einer weiteren Kunststoffkomponente). Insbesondere bei der Verwendung von Halbschalen ist es möglich, den Hohlraum von der Hartkomponente 10 vollständig zu umschliessen. Es ist jedoch auch denkbar, den Hohlraum offen zu lassen oder mittels eines Deckels zu verschliessen.

Ausserdem ist es möglich, dass in einem Körper mehrere getrennte oder verbundene Hohlräume gestaltet werden. Die Hohlräume - beziehungsweise der Hohlraum - können einseitig oder zweiseitig offen sein oder mittels eines Abdeckelements verschlossen werden.

Grundsätzlich ist auch die Möglichkeit gegeben, einen oder mehrere Hohlräume analog Fig. 25 bei den Ausführungsformen gemäss den Fig. 19 - 26 vorzusehen. Dazu würden der oder die Hohlräume vorzugsweise in einer der Hartkomponenten 10 beziehungsweise 48 platziert. Die weiche Komponente 62 kann ebenfalls eingesetzt werden, ist aber aufgrund der Flexibilität weniger zur Positionierung von elektrischen Komponenten geeignet.

Beim in der Figur 26 gezeigten Querschnitt verläuft die erste Hartkomponente 10 beispielhaft mit einem nahezu rechteckigen Querschnitt in Längsrichtung der Zahnbürste.

Die oben liegenden und unten liegenden Seiten der ersten Hartkomponente 10 sind bezüglich der Achse konzentrisch geformt, wobei die unten liegende Seite an der Peripherie des Querschnitts des Griffteils 64 liegt und die oben liegende Seite in radialer Richtung weiter innen verläuft.

Im Mittelbereich sind die in der Figur 26 rechts und links liegenden Seiten der ersten Hartkomponente 10 konkav ausgebildet, oben und unten bis zu einem Radius, welcher der oberen Seite entspricht. An das untere Ende der genannten konkaven Ausbildung schliesst je eine weitere konkave Ausbildung an bis zur unten liegenden Seite der ersten Hartkomponente 10, welche in Umfangsrichtung gemessen kürzer ausgebildet ist als die oben liegende Seite. Die erste Hartkomponente 10 ist im Querschnitt vollständig, von einem metallischen Überzug 44 bedeckt. Dieser metallische Überzug 44 liegt im Bereich der Unterseite des Griffteils 64 frei. Die beidseitig durch die mittig angeordnete konkave Ausführungsform der ersten Hartkomponente 10 gebildeten Ausnehmungen/Troge sind im Mehrkomponentenspritzgussverfahren mit einer zweiten Hartkomponente 48 aufgefüllt, welche in radialer Richtung aussen die beispielhafte Kreisform der oberen Seite der ersten Hartkomponente 10 weiterführt. Anschliessend ist ebenfalls mittels Mehrkomponentenspritzguss, radial aussen, ein Mantel aus weicher Komponente 62 angebracht, welcher die Oberseite der ersten Hartkomponente 10 und die zweite Hartkomponente 48 umklammert und bis zur unteren, frei liegenden Seite der ersten Hartkomponente 10 reicht. Die weiche Komponente 62 geht mit der zweiten Hartkomponente 48 eine Haftung, einen Materialschluss, ein, so dass die erste Hartkomponente 10 partiell, jedoch fest umschlossen ist. Im Bereich wo die weiche Komponente 62 den metallischen Überzug 44 der ersten Hartkomponente 10 berührt, entsteht kein Materialschluss. Selbstverständlich ist es bei dieser Ausführungsform denkbar, in einem anderen Querschnitt die weiche Komponente 62 in Umfangsrichtung in sich geschlossen auszubilden, so dass die unten liegende Seite der ersten Hartkomponente 10 inselartig frei liegt und von der weichen Komponente 62 umgeben ist.

Da die erste Hartkomponente 10, die zweite Hartkomponente 48 und die weiche Komponente 62 mittels Spritzgiessen, vorzugsweise Mehrkomponentenspritzgiessen, hergestellt werden, können diesen Teilen praktisch beliebige, dreidimensionale Volumenformen vermittelt werden. Es gibt keine Limitierung auf die gezeigten kreisförmigen Querschnitte; die Form des Querschnitts kann, unter Einhaltung der in den Fig. 19 - 26 dargestellten Konzepte, in den Anordnungen und Flächenaufteilungen variieren. So kann auch die Form der Arme 82 im Querschnitt sowohl vom Umriss her als auch von der Grösse/Skalierung her verschieden gestaltet werden.

So ist es möglich, die gezeigten Querschnitte ineinander übergehend zu lassen. Weiter ist es denkbar, bei sämtlichen gezeigten Ausführungsformen Hohlräume vorzusehen. Überdies ist es möglich, bei allen gezeigten Ausführungsformen die weiche Komponente 62 durch eine dritte Hartkomponente zu ersetzen. Bei allen gezeigten Ausführungsformen gibt es zwischen dem metallischen Überzug 44 und der zweiten Hartkomponente 48 beziehungsweise weichen Komponente 62 keine oder nur eine vernachlässigbare Haftung, hingegen haftet die Weichkomponente 62 an der zweiten Hartkomponente 48, jedoch nicht am metallischen Überzug 44 der ersten Hartkomponente 10. Die mechanische Befestigung der zweiten Hartkomponente an der ersten Hartkomponente 10 erfolgt durch Ausnützung der Formgebung und des Schwundverhaltens der zweiten Hartkomponente 48. Mögliche Massnahmen zur Verbesserung der Hafteigenschaften zwischen dem metallischen Überzug 44 und der weiteren Kunststoffkomponente 46 sind weiter unten beschrieben. Diese sind jedoch weniger bevorzugt, da aufwendig.

Es ist zu beachten, dass die Form der ersten Hartkomponente 10 möglichst keine aussen liegenden scharfen Kanten besitzt (einspringende und nach aussen stehende Kanten), da diese aus beschichtungstechnischen Gründen ein Problem bzw. eine Grenzstelle auf der Oberfläche darstellen. Solche scharfen Kanten können durch eine entsprechende Rundung der Kante bereinigt werden. Die einzelnen Materialanteile in den Figuren sind zudem flächig und nicht folienartig ausgeformt. Die einzelnen Hartkomponenten 10, 48 nehmen bei allen Figuren einen wesentlichen Anteil der Querschnittsfläche ein. Die Querschnittsfläche des metallischen Überzugs 44 ist demgegenüber vernachlässigbar klein. Bei allen Figuren ist mindestens ein Teil des metallischen Überzugs 44 von einer weitern Komponente überspritzt und dadurch abgedeckt.

Wie im Zusammenhang mit den Figuren beschrieben, muss die erste Hartkomponente 10 - nicht erfindungsgemäss - nicht vollständig mit dem metallischen Überzug 44 bedeckt sein. Insbesondere ist es eine nicht erfindungsgemäße Alternative, die erste Hartkomponente 10 bei allen Figuren transluszent oder transparent auszugestalten und den metallische Überzug 44 nur im Bereich oder einem Teilbereich der sich berührenden Oberflächen zwischen der ersten Hartkomponente 10 und der zweiten Hartkomponente 48 anzubringen.

Einzelne Oberflächenelemente der ersten Hartkomponente 10 können frei stehen und allenfalls mit den weiteren Komponenten 46, 62 eine Verbindung eingehen, d.h. einen Materialschluss bilden.

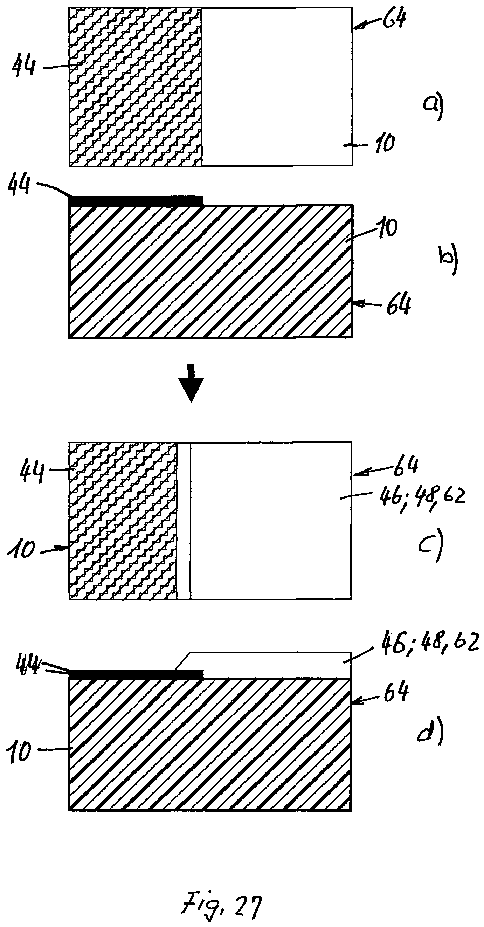

Figur 27 a) und b) zeigen in Draufsicht beziehungsweise im Schnitt einen Ausschnitt aus dem Griffteil 64 einer weiteren Ausführungsform für eine nicht erfindungsgemässe Zahnbürste. Die erste Hartkomponente 10 ist in diesem Fall nicht vollständig, sondern partiell mit dem metallischen Überzug 44 versehen. Wie die Figuren 27 c) und d) zeigen, ist an die vom metallischen Überzug 44 freie Zone der ersten Hartkomponente 10 mittels Mehrkomponentenspritzguss eine weitere Kunststoffkomponente 46 angespritzt; es kann sich um eine zweite Hartkomponente 48 oder um eine weiche Komponente 62 handeln. Zwischen der ersten Hartkomponente 10 und der weiteren Kunststoffkomponente 46 resultiert bei der Verwendung von affinen, d.h. kompatiblen Kunststoffen eine Haftung. Die weitere Kunststoffkomponente 46 überdeckt den metallischen Überzug partiell, im Randbereich.

Der Begriff Mehrkomponentenspritzguss beinhaltet in dieser Schrift sowohl das Anspritzen mehrerer verschiedener oder gleicher Kunststoffkomponenten im gleichen Werkzeug auf einer Maschine oder das sequentielle Spritzen von Kunststoffkomponenten in verschiedenen Werkzeugen auf verschiedenen Spritzgussmaschinen.

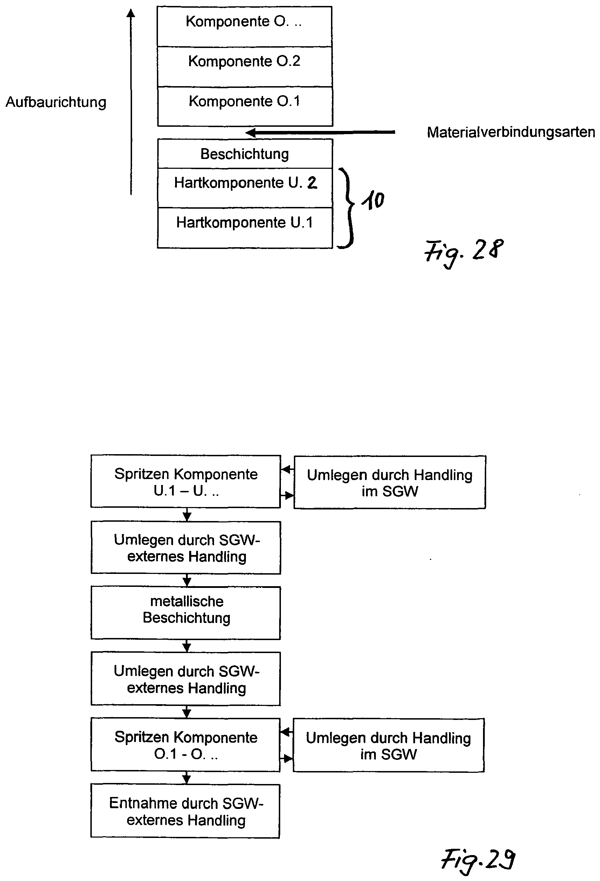

Figur 28 zeigt rein schematisch den grundsätzlichen Schichtaufbau einer erfindungsgemässen Zahnbürste. Die erste Hartkomponente 10 kann, wie weiter oben beschrieben, aus einem einzigen harten Kunststoff in einem einzigen Schritt hergestellt werden. Es ist jedoch auch denkbar, dass in eine erste Kavität eines Mehrkomponentenspritzgusswerkzeugs eine erste Hartkomponente U.1 eingespritzt wird, dann der gespritzte Formling in eine zweite Kavität umgelegt wird und dort eine weitere Portion U.2 des gleichen Kunststoffs oder ein anderer harter Kunststoff angespritzt wird. Grundsätzlich ist es möglich, die erste Hartkomponente 10 aus noch mehr Schichten des gleichen harten Kunststoffs oder aus weiteren Schichten unterschiedlichen, harten Kunststoffs auszubilden. Unterschiedliche Schichten aus verschiedenen harten Kunststoffen können natürlich bei Verfahren zur metallischen Beschichtung unterschiedlich reagieren und damit zusätzliche Freiheitsgrade bei der Beschichtung erlauben. Die so gebildete erste Hartkomponente 10 ist mit dem metallischen Überzug 44 versehen, was in Figur 28 mit "Beschichtung" angedeutet ist. Die beschichtete erste Hartkomponente 10 wird anschliessend in eine weitere Kavität des Mehrkomponentenspritzgusswerkzeugs eingesetzt, wo eine weitere Kunststoffkomponente 46, in Figur 28 mit "Komponente O.1" bezeichnet eingespritzt wird.

Es handelt sich dabei um die zweite Hartkomponente 48, welche als Basis zum Anspritzen einer weiteren Hart- oder Weichkomponente dient, welche in Figur 28 mit "Komponente O.2" bezeichnet ist. Es ist denkbar, in einer weiteren Kavität eine weitere Kunststoffkomponente, in Figur 28 mit "Komponente O..." angedeutet, anzuspritzen oder diese Schritte noch weiter zu wiederholen.

Vorzugsweise liegen die Hartmaterialschichten unterhalb der Weichmaterialschichten beziehungsweise werden die Hartmaterialschichten vor den Weichmaterialschichten gespritzt. Die Fig. 28 ist auch im Zusammenspiel mit den Figuren 19 - 26 zu lesen.

Mit "Materialverbindungsarten" sind die unterschiedlichsten Möglichkeiten zum Befestigen der Komponente O.1 an der mit dem metallischen Überzug 44 versehenen ersten Hartkomponente 10 symbolisiert, beispielsweise das mechanische form- und / oder kraftschlüssige Verbinden oder auch weiter unten diskutierte Verbindungsarten.

Der in der Figur 28 gezeigte Schichtaufbau ist mit den Verfahrensschritten erzielbar, wie sie in Figur 29 angedeutet sind. In einem Spritzgusswerkzeug (SGW) wird die Hartkomponente U.1, oder werden nacheinander die Hartkomponenten U.1, U.2 und gegebenenfalls weitere Hartkomponenten zur Bildung der ersten Hartkomponente 10 gespritzt, wobei zwischen den einzelnen Spritzvorgängen jeweils ein Umlegen des Formlings in die nächste Kavität des Mehrkomponentenspritzgusswerkzeuges erfolgt. Das Umlegen wird in bevorzugter Weise durch ein Handling Gerät oder einen Roboter getätigt, welches in bekannter Art und Weise im Spritzgusswerkzeug ein- bzw. an diesem angebaut oder darin integriert ist. Bei einem Aufbau mit verschiedenen Werkzeugen beziehungsweise Spritzgussmaschinen kann ebenfalls eine automatische Verbindung beispielsweise mittels eines Transportsystems zwischen den Kavitäten der einzelnen Spritzgusswerkzeuge vorliegen. Dieses Transportsystem kann direkt mittels Kette oder Zugmitteltrieb funktionieren. Bevorzugt wird eine flexible Lösung mit Puffermöglichkeit zwischen den einzelnen Spitzgiesswerkzeugen (z.B Shuttles). Selbstverständlich stimmen bei einer automatischen Verknüpfung der Spritzgusswerkzeuge die Durchlaufzeiten bzw. Taktzeiten zwischen den einzelnen Stationen überein.

Nach erfolgter Fertigstellung der ersten Hartkomponente 10 wird diese, vorzugsweise mittels eines externen Handling Geräts, dem Spritzgusswerkzeug entnommen und einem Förder- oder Ablagesystem übergeben bzw. darin abgelegt. Dann erfolgt die metallische Beschichtung zur Herstellung des metallischen Überzugs 44 ausserhalb des Spritzgusswerkzeugs, wobei das Förder- oder Ablagesystem spezifisch ausgelegt ist, sodass eine optimale Verbindung zwischen dem Spritzgiessen und dem Beschichten entsteht.

Die mit dem metallischen Überzug 44 versehene erste Hartkomponente 10 wird dann wiederum mittels eines externen Handling Geräts in die betreffende Kavität des Spritzgusswerkzeugs eingesetzt, wo das Einspritzen der Komponente O.1 erfolgt. Ist eine weitere Komponente 0.2 oder sind noch weitere Komponenten O... anzuspritzen, erfolgt jeweils in bekannter Art und Weise ein Umlegen durch das Handling Gerät des Spritzgusswerkzeugs. Letzterem wird der fertige Zahnbürstenkörper mittels eines externen Handling Geräts entnommen. Bei einem Aufbau mit verschiedenen Werkzeugen beziehungsweise Spritzgussmaschinen für die Komponenten O.1 etc. kann ebenfalls eine automatische Verbindung, ein Transportsystem zwischen den Kavitäten vorliegen.

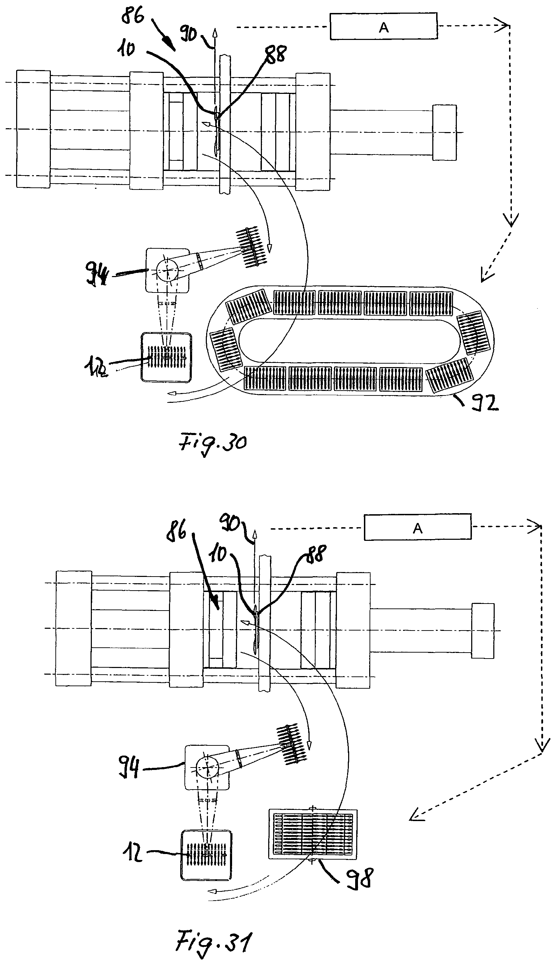

Figur 30 zeigt rein schematisch einen möglichen apparativen Aufbau zur Durchführung des in Zusammenhang mit Figur 28 und 29 erläuterten Verfahrens. In einem Mehrkomponentenspritzgusswerkzeug 86 wird die erste Hartkomponente 10 in einem, zwei oder mehreren Schritten gespritzt, wobei das Umlegen innerhalb des Spritzgusswerkzeugs durch ein internes Handling Gerät 88 erfolgt; das Umlegen könnte auch mit einem externen Handlinggerät erfolgen. Die fertig gestellte erste Hartkomponente 10 wird mittels eines externen Handling Geräts 90 dem Mehrkomponentenspritzgusswerkzeug 86 entnommen und abgelegt. Die Ablage kann in sogenannte Trays erfolgen, welche angepasste Aufnahmen für die ersten Hartkomponenten 10 aufweisen. Es ist jedoch auch denkbar, die ersten Hartkomponenten 10 in Behälter ohne Aufnahme geordnet abzulegen oder im den Behälter ungeordnet fallen zu lassen. Die ersten Hartkomponenten 10 werden dann der in Figur 30 mit A bezeichneten Station zur Erzeugung des metallischen Überzugs 44 zugeführt.

Es ist denkbar, dass die ersten Hartkomponenten 10 während des gesamten Metallisierungsprozesses im gleichen Behältnis (Tray, Behälter, Aufhängung, Halterung, Raster, Gestell, Gitter etc.) verbleiben. Dies hat den Vorteil, dass die ersten Hartkomponenten 10 während des Metallisierungsprozesses nicht umgepackt werden müssen. Alternativ kann die erste Hartkomponente 10 auch aus dem Behältnis mittels Handlingsystem für den Metallisierungsprozess entnommen und nach dessen Abschluss wieder zurückgelegt werden.

Die mit dem metallischen Überzug 44 versehenen ersten Hartkomponenten 10 werden im in Figur 30 gezeigten Beispiel in Trays zurückgelegt, welche einem Umlaufsystem oder Transportsystem 92 zugeführt werden. In diesem sind die mit ersten Hartkomponenten 10 bestückten Trays hintereinander angeordnet, wobei es im Umlaufsystem 92 möglich ist, weitere Prozesse durchzuführen. Es könnten beispielsweise weitere Elemente, Bauteile oder Dekorationsschritte durchgeführt werden. Ein weiteres externes Handling Gerät 94, im vorliegenden Fall ein Roboter, entnimmt dann jeweils einem Tray die beschichteten ersten Hartkomponenten 10 und führt diese in die betreffenden Kavitäten des Mehrkomponentenspritzgusswerkzeugs 86 ein. Nach diesem Einsetzen übernimmt das externe Handling Gerät 94 die fertig gestellten Zahnbürstenkörper 12 und legt diese geordnet oder chaotisch in Behältnisse 96 ab.

Selbstverständlich ist es denkbar, anstelle dieser Behältnisse 96 eine Fördereinrichtung, beispielsweise ein Förderband, vorzusehen, um die Zahnbürstenkörper 12 zum Beborsten direkt einer Stopfmaschine zuzuführen. Die Aufgabe des Handling Geräts 90 kann auch vom Handling Gerät 94 übernommen werden.

Bei der in der Figur 31 dargestellten Einrichtung zum Herstellen erfindungsgemässer Zahnbürstenkörper 12 liegt der einzige Unterschied zur Einrichtung gemäss Figur 30 darin, dass die mit dem metallischen Überzug 44 versehenen ersten Hartkomponenten 10 in Trays nicht einem Umlaufsystem 92 zugeführt, sondern einem um eine Horizontalachse rotierbaren Magazinsystem 98 übergeben werden. Das externe Handling Gerät 94 übernimmt die beschichteten mit dem metallischen Überzug 44 versehenen ersten Hartkomponenten 10 diesem Magazinsystem 98.

Anstelle der in Fig. 30 eingesetzten, einzigen Mehrkomponentenspritzgussanlage, können an einem grösser ausgelegten Umlaufsystem mehrere Spritzgiessmaschinen stehen, welche die Spritzlinge, je nach Verfahrensstadium, aus dem Transportsystem 92 mittels Handling Gerät 94 dem nächsten Spritzgussschritt U.1, U.2 ... , 0.1,0.2... zuführen.

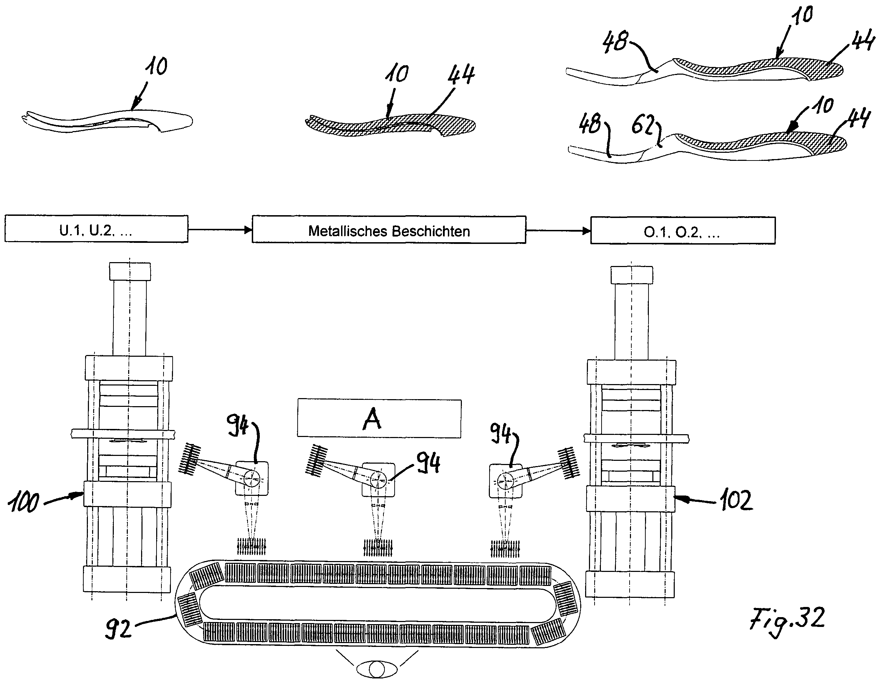

Figur 32 zeigt den schematischen Aufbau einer solchen Anlage. Darin sind auch die Verfahrenschritte beispielhaft anhand der Zahnbürste gemäss den Figuren 1 - 9 dargestellt. Die Herstellung der ersten Hartkomponente 10 kann mit einer ersten Spritzgussmaschine 100 verrichtet werden. Dabei kann es sich, wie im Zusammenhang mit Fig. 28 beschrieben, um mehrere Spritzgussschritte U.1, U.2, ... handeln. Beispielhaft ist die in Fig. 1 dargestellte erste Hartkomponente 10 in der Fig. 32 nur in einem einzigen Spritzgussschritt hergestellt.

Wie in der Fig. 32 gezeigt, können in einem weiteren Schritt an diesem Transportsystem 92 'inline', d.h. automatisch mittels Handling verknüpft, auch Verfahrensschritte zur metallischen Beschichtung und oder Lackierung zur Erzeugung des metallischen Überzugs 44 integriert werden (A). Auch dieser Arbeitsgang kann falls nötig in mehrere automatisch an das Transportsystem 92 gekoppelte Teilschritte unterteilt werden (Primer, Metallisierung, Schutzlack, etc.). Für dieses mit dem Spritzgussprozess automatisch verknüpfte metallische Beschichten eignet sich vor allem der CVD, PVD, bzw. der Sputter Prozess oder der Heissprägeprozess.

In einem nächsten Schritt werden auf einer weiteren Spritzgiessanlage 102 die weiteren Kunststoffkomponenten O.1, O.2,... verarbeitet. Beispielhaft sind die in Fig. 5 und 8 dargestellten weiteren zweiten Hartkomponenten 48 und weichen Komponenten 62 gezeigt. Das Transportsystem verfügt über einzelne Umlauf-Trays zur Aufnahme der Spritzlinge in den verschiedenen Verfahrensstadien. Dieser Aufbau erlaubt es, zwischen den einzelnen Verfahrensschritten eine Pufferstrecke aufzubauen um kleinere Störungen zu überbrücken. Dabei sind die Trays vom Zugmitteltrieb des Transportsystems entkoppelt. Der Einsatz eines streng getakteten Umlaufsystems ist ebenfalls möglich, aber weniger bevorzugt. In diesem Fall wäre das Tray oder der Werkstückträger unmittelbar mit dem Zugmitteltrieb oder der Kette gekoppelt. Handlingsgeräte 94 beziehungsweise Roboter sind mit 94 bezeichnet.

Zur Herstellung der ersten Hartkomponente 10 sind folgende Kunststoffe besonders geeignet: Polyvinylchlorid (PVC), Polyamid (PA), Polyester (PET), Acrylbuthadienstyrol (ABS oder ABS Blend), Styrolacrylnitril (SAN), Polypropylen (PP), Polycyclohexandimethanoltherasthalat (PCT; PCT-A (säuremodifiziert); PCT-G (glykolmodifiziert)), Polyethylen (PE, wie beispielsweise BR003 von Eastman Chemical Company), Polystyrol (PS) oder Polymethylmethacrylat (PMMA). In bevorzugterweise wird Polystyrol, Acrylbuthadienstyrol oder Polypropylen mit einem E-Modul von 1000 - 2400 N/mm², in besonders bevorzugterweise von 1300 - 1800 N/mm² eingesetzt.

Als zweite Hartkomponente 48 werden bevorzugt Polyvinylchlorid (PVC), Polyamid (PA), Polypropylen (PP), Polyester (PET), Polycyclohexandimethanoltherasthalat (PCT; PCT-A (säuremodifiziert); PCT-G (glykolmodifiziert)), Polyethylen (PE, wie beispielsweise BR003 von Eastman Chemical Company), Polystyrol (PS), Styrolacrylnitril (SAN), Polymethylmethacrylat (PMMA) oder Acrylbuthadienstyrol (ABS oder ABS Blend) verwendet. Glasklare Kunststoffe wie SAN, ABS oder PS werden bevorzugt als zweite Hartkomponente 48 eingesetzt um die metallisierte Oberfläche der Hartkomponente zu zeigen, selbst wenn diese durch die weitere Hartkomponente 48 durch Überspritzen abgedeckt ist.

Es sei auch ausdrücklich erwähnt, dass für die Materialkomponenten U und O in Fig. 28 mehrfach dasselbe Material eingesetzt werden kann - allenfalls mit verschiedenen Zusätzen wie Farben, Metallpartikeln etc. Beispielsweise kann in einer bevorzugten Variante die mit dem metallischen Überzug zu versehende erste Hartkomponente 10 aus PP bestehen und die zweite Hartkomponente ebenfalls aus PP. Bei einem mindestens teilweise transparenten Zahnbürstengriff könnte als erste Hartkomponente 10 beispielsweise PS, SAN oder ABS eingesetzt werden. Die zweite Hartkomponente könnten entsprechend ebenfalls aus PS, SAN oder ABS bestehen.

Für die weiche Komponente 62 eignen sich insbesondere Polyvinylchlorid (PVC), Polyethylen (PE), mit tiefer Dichte (PE-LD, low density polyethelene) oder hoher Dichte (PE-HD, high density polyethelene), gummielastischer Werkstoff wie Polyuretan (PUR), insbesondere thermoplastisches Elastomer (TPE). Die Shore A-Härte der weichen Komponente 62 liegt vorzugsweise unter 90. Bevorzugt wird ein thermoplastisches Elastomer (TPE) verwendet, welches vorzugsweise mit mindestens einer der Hartkomponenten U oder O eine Verbindung eingeht.

Nicht erfindungsgemäss wird die erste Hartkomponente 10 aus transparentem PET, PCT-A, PCT-G oder ABS mittels Spritzguss gefertigt und mittels CVD, PVD, oder Sputter Prozess teilweise metallisch beschichtet.

Anschliessend wird mindestens der gesamte mit dem metallischen Überzug 44 versehene Bereich mittels PP als zweite Hartkomponente 48 überspritzt. Die Verbindung zwischen der ersten Hartkomponente 10 und der zweiten Hartkomponente 48 wird ohne Materialschluss (ohne eigentliche Haftung der Materialkomponenten) mittels Form und Kraftschluss durch eine Schwundverbindung realisiert. Die Berührungsflächen gehen dabei miteinander keine eigentliche Verbindung ein. Mittels zerschneiden des Griffteiles kann dieser Umstand leicht festgestellt werden.

Schliesslich wird eine weiche Komponente 62 aus TPE an die zweite Hartkomponente 48 angespritzt. Vorzugsweise überdeckt die weiche Komponente 62 die erste Hartkomponente 10 nur indirekt.

Die Zahnbürsten bzw. deren Zahnbürstenkörper 12 haben eine Länge bis zu 220 mm, für Erwachsene vorzugsweise zwischen 190 mm - 200 mm und für Kinder von 120 mm - 140 mm.

Die Länge des Griffsteils 64 beträgt zwischen 45 % und 65 % der Gesamtlänge der Zahnbürste bzw. des Zahnbürstenkörpers 12. Die verbleibende Länge wird zwischen dem Halsteil 52 und Kopfteil 14 aufgeteilt, wobei die Borstenfeldlänge vorzugsweise zwischen 26 mm und 30 mm oder zwischen 15 mm und 24 mm liegt.

Die Erzeugung des metallischen Überzugs 44 an der ersten Hartkomponente 10 kann beispielsweise durch Galvanisieren nach einem allgemein bekannten Verfahren mit folgenden Schritten durchgeführt werden:
1. Beizvorgang: Dabei wird die Oberfläche der ersten Hartkomponente 10 derart behandelt, dass die Haftung der nächsten Schicht gewährleistet ist.
2. Schicht 1 chemischer Nickel: Auf die gebeizte erste Hartkomponente 10 wird eine Schicht von 0,1 Mikrometer - 0,5 Mikrometer chemischen Nickels aufgebracht. Diese Schicht dient als Grundierung.
3. Schicht 2 elektrolytischer Nickel: Diese Nickelschicht von 1 Mikrometer - 5 Mikrometer dient ebenfalls als Grundierung.
4. Schicht 3 Kupfer: Die Kupferschicht hat eine Dicke von 8 Mikrometer - 30 Mikrometer und dient dem Spannungsabbau auf der Oberfläche.
5. Schicht 4 Nickel: Auf die Kupferschicht wird nochmals eine Nickelschicht der Dicke 5 Mikrometer - 20 Mikrometer aufgebracht, welche das Haften der Schicht 5 ermöglicht. Die Ausgestaltung dieser Schicht bestimmt im Wesentlichen das glänzende oder matte Aussehen der finalen Beschichtung.
6. Schicht 5 Chrom/Gold: Chrom oder Gold wird in einer Dicke von 0.1 Mikrometer - 1 Mikrometer aufgetragen. Diese Schicht bildet die äusserste Schicht des metallischen Überzugs 44 und bestimmt das farbliche Erscheinungsbild des Überzugs.

Ein unterschiedlicher Schichtaufbau ist denkbar. Beispielsweise kann Nickel, der giftig ist, durch Nickelersatzmaterialien, wie beispielsweise Palladium ersetzt sein. Dadurch kann der Einsatz giftiger Inhaltsstoffe für die Beschichtung im Wesentlichen vermieden werden, die beschriebenen problematischen Punkte des Berührens giftig beschichteter Stellen werden ausgeschaltet. Neben einer verchromten oder goldigen Oberfläche kann der metallische Überzug 44 auch einen vernickelten oder einen verkupferten Eindruck hinterlassen; das Galvanisierverfahren und der Schichtaufbau bleiben gleich, es wird jedoch für eine verkupferte Oberfläche nach dem Anbringen der Schicht 3 und für eine vernickelte Oberfläche nach dem Auftragen der Schicht 4 abgebrochen.

Bei den meisten, weiter oben gezeigten Ausführungsformen wird die erste Hartkomponente 10 vollständig mit dem metallischen Überzug 44 versehen. Es ist jedoch auch denkbar, die erste Hartkomponente 10 - nicht der Erfindung entsprechend - nicht vollständig in die Galvanik-Bäder einzutauchen - vergleiche Figur 27 -, so dass die erste Hartkomponente 10 nur partiell beschichtet wird. Es ist angestrebt, die erste Hartkomponente 10 nicht abzudecken, um beim Galvanisieren vom metallischem Überzug freie Zonen zu erhalten. Bei einer nicht vollständigen Beschichtung der ersten Hartkomponente 10 wird darauf geachtet, die Übergangsstellen von beschichtet zu unbeschichtet mit weiteren angespritzten Komponenten zu überdecken, um die potentielle Ablösungsstelle zu vermeiden. Es wird ebenfalls vorgeschlagen, die im Metallisierungsprozess notwenigen Auflage oder Verankerungselemente, welche zur Zuführung in den Metallisierungsprozess an der ersten Hartkomponente 10 notwenig sind, mit einer weiteren Komponente zu überspritzen. Diese Stellen sind oft ungenügend oder unschön metallisiert.

Es ist auch denkbar, den metallischen Überzug 44 mittels CVD, PVD oder Sputtern zu erzeugen. In bekannter Art und Weise werden Ionen mit hinreichender Energie auf ein Target geschossen, aus welchem die gewünschten Atome (bzw. Moleküle) herausgeschlagen werden. Diese Atome (bzw. Moleküle) fliegen zur ersten Hartkomponente 10 und erzeugen dort den gewünschten metallischen Überzug 44.

Gegebenenfalls ist es notwendig, die erste Hartkomponente 10 zur Verbesserung der Haftung der Atome/Moleküle vorzubehandeln. Selbstverständlich kann die erste Hartkomponente 10 auch mittels dieses Verfahrens, wie beschrieben, (nicht erfindungsgemäss) nur teilweise mit einem metallischen Überzug 44 beschichtet werden. Da es sich um keine Tauchverfahren handelt, genügt es, eine Aufnahme oder Maske bzw. einen Träger für die erste Hartkomponente 10 während dem Sputter Prozess zu gestallten, mittels welchem nur der zu beschichtende Teil der Oberfläche der ersten Hartkomponente 10 für den Prozess exponiert sind. Dieser Metallisierungsprozess eignet sich bevorzugt für eine ,Inline' Fertigung mittel Transportsystem.

Auch mittels Plasmabeschichten kann auf der ersten Hartkomponente 10 der metallische Überzug 44 erzeugt werden. In bekannter Art und Weise werden die gewünschten Atome (bzw. Moleküle) aus einem Plasma extrahiert, welche sich dann an der ersten Hartkomponente 10 anlagern.

Der metallische Überzug 44 der ersten Hartkomponente 10 kann auch mittels eines RIM-Verfahrens (Reaction Injection Molding Verfahren), durchgeführt werden. Die erste Hartkomponente 10 wird im Spritzgusswerkzeug hergestellt, danach vorzugsweise in eine weitere Kavität eingelegt, in welche ein PU Gemisch eingespritzt wird. Das PU Gemisch reagiert und härtet aus.

Schlussendlich wäre auch Heissprägen oder ein Decal Verfahren denkbar. Dabei wird der metallische Überzug 44 bzw. ein Motiv mittels eines Werkzeugs mit Hilfe einer pigmentierten Folie unter Einfluss von Druck, Temperatur und Zeit flächig bzw. linear auf die Oberfläche der ersten Hartkomponente 10 übertragen. Dabei kann die dazu benötigte Heissprägefolie oder Decalfolie zusätzlich bedruckt oder anderweitig dekoriert sein. Diese Technologie erlaubt es insbesondere auf sehr günstige Art und Weise einen nicht erfindungsgemässen partiellen, metallischen Überzug zu erzeugen. Es ist auch denkbar, mehrere sequentielle Heissprägestationen für unterschiedliche metallische Oberflächenanteile der ersten Hartkomponente 10 einzusetzen. Ein weiterer Vorteil der Heissprägetechnologie besteht darin, dass dieser Prozess voll automatisiert direkt an der Spritzgussmaschine stattfinden kann. Mit anderen Worten können die ersten Hartkomponenten automatisch aus dem Spritzgusswerkzeug entfernt, geprägt und wieder ins Spritzgusswerkzeug eingelegt werden. Bezug nehmend auf Fig. 30 wäre der Präge-Prozess A direkt im Umlaufsystem 92 integriert. Das Handlingsystem würde die erste Hartkomponente zum Prägen aus dem Spritzgusswerkzeug entnehmen und auf das Umlaufsystem 92 legen und nach erfolgter Prägung wieder in das Spritzgusswerkzeug einlegen. Selbstverständlich funktioniert dieser Vorgang auch mit separaten Spritzgusswerkzeugen und Spritzgussmaschinen. Selbstverständliches eignet sich dieses Verfahren auch für das oben beschrieben Verfahren mit Transportsystem und mehreren unabhängigen Spritzgusswerkzeugen, Fig. 32.

Um ein optimales Haften der Schichten zu gewährleisten ist es möglich, die erste Hartkomponente 10 vor der Beschichtung vorab zu behandeln, beispielsweise durch Entfetten, Ätzen, Beflammen, Corona-Vorbehandlung, Beschichtung mit Haftvermittler oder Primer. Das Beschichten der metallischen Oberfläche mittels Schutzlack kann bei einigen Beschichtungsverfahren ebenfalls nötig sein.

Auch diese Beschichtungsschritte können 'Inline' in ein Transportsystem integriert werden.

Die Oberfläche der unbeschichteten ersten Hartkomponente 10 hat einen wesentlichen Einfluss auf das Aussehen der beschichteten Oberfläche. Die Rauhigkeit entscheidet in gewisser Weise darüber, ob die Oberfläche glatt oder rau ist. Durch die Gestaltung einer Oberflächenstruktur der ersten Hartkomponente 10 können die haptischen Eigenschaften auch auf der metallischen Beschichtung verändert werden. Elemente, die in die Oberflächenstruktur integriert werden, können sind beispielsweise Noppen, Rippen, Wabenstrukturen etc. Die Oberfläche ist dadurch strukturiert.

Die Haptik der Oberfläche der metallisch beschichteten ersten Hartkomponente 10 kann ausserdem durch das Anbringen von flächigen Elementen aus weichem Material, vorzugsweise aus Polyvinylchlorid (PVC), verbessert werden. Diese flächigen Elemente (Pad) werden auf die fertige Oberfläche geklebt. Der Pad hat auf der einen Seite einen Klebstoff o.ä. angebracht, welcher die Verbindung zur beschichteten ersten Hartkomponente 10 sicherstellt. Die andere Seite des Pads besteht aus einer Weichkomponente, welche in Form einer Haltverbesserung geformt ist, beispielsweise in Form von Noppen, Rippen, etc.

Anstelle oder zusätzlich zur metallischen Beschichtung wäre es auch möglich, die erste Hartkomponente 10 mit Wirksubstanzen zu behandeln, welche beim Berühren der beschichteten ersten Hartkomponente an der Berührungsstelle auf den berührenden Körper übergehen.

Alternativ oder zusätzlich könnte die erste Hartkomponente bedruckt, lackiert, bemalt oder mit anderen bekannten Dekorationsverfahren versehen werden. Auch weitere für Hartkunststoffe realisierbare Oberflächenbehandlungen /beschichtungen könnten angewendet werden. Die Lackierung kann, wie in Fig. 32 gezeigt, als zusätzlicher oder alternativer Schritt 'Inline' zwischen den Spritzgussverfahren eingesetzt werden.

Schlussendlich ist es auch denkbar, eine sich bei Gebrauch abnutzende Beschichtung anzubringen. Diese kann beispielsweise eine Indikator-Funktion für das Ersetzen der Bürste oder zum Anzeigen der Putzdauer übernehmen.

Der Zahnbürstenkörper 12 einer bevorzugten erfindungsgemässen Zahnbürste ist an der Oberfläche nur partiell mit dem metallischen Überzug 44 versehen, da wenigstens im Griffteil der metallische Überzug bereichsweise mit einer weiteren Kunststoffkomponente überdeckt ist. Bei Zahnbürsten liegt der metallische Überzug 44 vorzugsweise nur im Griffteil, d.h. vom borstenfreien Ende bis zum Ansatz des Halsteils, an der Oberfläche frei. Dies bietet den Vorteil, dass vor allem starre Bereiche der Zahnbürste beschichtet werden, welche sich unter der Belastung, welche durch die Nutzung entsteht, nicht oder nur wenig verformen. Eine Verformung kann mit sich bringen, dass die spröde metallische Beschichtung bricht und es zu unerwünschten, partiellen Ablösungen kommt.

Die Befestigung der zweiten Hartkomponente 48, an der mit dem metallischen Überzug 44 versehenen ersten Hartkomponente 10 kann auf mechanische Art erfolgen, wie dies im Zusammenhang mit den Ausführungsbeispielen weiter oben erläutert ist. Bevorzugt erfolgt die mechanische Verankerung form- und kraftschlüssig - d.h. Verkrallen von Kunststoffkomponenten; in bevorzugter Weise durch Ausnützung des Schwundeffekts mittel Spritzguss der zweiten Hartkomponente 48 über die erste Hartkomponente 10. Selbstverständlich sind auch andere mechanische Verbindungsprozesse denkbar.

Die Befestigung kann auch dazu benutzt werden, mehrere, nicht verbundene Elemente beschichteter erster Hartkomponenten 10 miteinander zu verbinden. In diesem Fall werden mehrere kleinere beschichtete Körper mittels einer Befestigung miteinander verbunden, um einen Teil einer Zahnbürste zu bilden. Die verschiedenen Körper können mit verschiedenen Beschichtungen versehen sein.

Um eine Haftung zwischen dem metallischen Überzug 44 und der weiteren Kunststoffkomponente 46 zu erreichen, ist es möglich, den betreffenden Kunststoff einen Haftvermittler beizugeben. Dieser befindet sich vorzugsweise bereits im Granulat, welches in der Spritzgusseinrichtung verwendet wird. Als Haftvermittler werden möglichst kommerziell erhältliche Produkte eingesetzt, welche vor allem in der Herstellung von Verbundfolien oder Verbundrohren Verwendung finden. Dabei handelt es sich beispielsweise um Maleinsäureanhydride (MSA), EBA, SB/PE Blockcopolymerisat, SB/PP Blockcopolymerisat, SB-Blends oder eine EthylenVinylacetat (EVA) Basis, wie EVAC.

Es ist auch denkbar, den metallischen Überzug 44 in jenen Bereichen, auf welche die weitere Kunststoffkomponente 46 aufgebracht wird, zu behandeln, beispielsweise mittels Aufrauhen, Ätzen oder dergleichen eine Oberflächenveränderung herbeizuführen, Lack (wie beispielsweise Chemlock 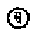 von Lord Chemical Products), einen Primer oder eine andere chemische Substanz aufzutragen. Auch mechanische Verfahren sind möglich, welche die Verbindung der weiteren Komponente 46 mit dem metallischen Überzug 44 ermöglichen.

Die auf diese Weise hergestellten Körper sind vom Gewicht her, verglichen mit reellen Metallkörpern, eher leicht. Der Metalleffekt wird nur in Bezug auf die Optik erreicht.

Um den Metall-Effekt zu unterstreichen, ist es auch möglich, Gewichte in Kunststoffkörper einzubringen, um den metallischen Effekt auch vom Gewicht her zu erreichen bzw. um die Zahnbürste aus zu balancieren. Beim Einsatz von Zusatzgewichten beträgt das Gewichts-Verhältnis von Griffpartie zu Kopfpartie mehr als 5:1 vorzugsweise mehr als 10:1; dabei wiegt das Zusatzgewicht mehr als 8 g vorzugsweise mehr als 12 g. Die Trennung von Griffpartie zu Kopfpartie passiert, gemessen vom Griff her, nach 70 % der Gesamtlänge der Zahnbürste. Das Zusatzgewicht oder die Zusatzgewichte werden in einen Kunststoffkörper eingebracht und durch geeignete Haltemittel oder Verbindungsverfahren, wie beispielsweise Vertiefungen, Rastnasen, Schnapper, Kleben am Körper fixiert, damit die Umspritzung stattfinden kann. Das Zusatzgewicht wird vorzugsweise vollumfänglich umspritzt. Es ist aber möglich, das Zusatzgewicht partiell nicht zu überspritzen und an die Oberfläche treten zu lassen. Diese Zusatzgewichte können aus Metall oder anderen im vgl. zu Kunststoffen mit höheren spezifischen Gewichten versehenen Materialien bestehen.

Es ist auch möglich, das Zusatzgewicht mit einer Kunststoffkomponente U oder O zu erzeugen, indem Metallpartikel während dem Spritzguss dieser Kunststoffkomponente verarbeitet werden (mittels Beigabe im Masterbatch). Dabei werden üblicherweise massiv höhere spezifische Gewichte erzielt als dies bei oben erwähnten Kunststoffkomponenten ohne Zusatz von Metallpartikeln möglich wäre. Vorzugsweise wird mit den Metallpartikeln das spezifische Gewicht dieser Kunststoffkomponente um über 10%, vorzugsweise über 30% erhöht.

Im Zusammenhang mit den in den Figuren 30 und 31 schematisch dargestellten Produktionseinrichtungen ist zu erwähnen, dass die Arbeitsstation A, in welcher die erste Hartkomponente 10 mit dem metallischen Überzug 44 versehen wird, offline betrieben werden kann. Das heisst, die Arbeitsstation A kann sich an einem anderen Ort als die übrigen Produktionsvorrichtungen befinden. Insbesondere kann sie räumlich abgetrennt sein. Die ersten Hartkomponenten 10 werden zur Arbeitsstation A transportiert, gegebenenfalls nach einer Zwischenlagerung.

Dort werden sie losgelöst vom Takt der Mehrkomponentenspritzgussmaschine mit dem metallischen Überzug 44 versehen. Die beschichteten ersten Hartkomponenten 10 werden dann, eventuell unter Zwischenschaltung einer Zwischenlagerung, zur Mehrkomponentenspritzgussmaschine zurücktransportiert. Der Vorteil des Offline-Betriebs zeigt sich darin, dass die erste Hartkomponente 10 erkaltet und geschwunden ist, wenn sie beschichtet wird. Zudem werden die Prozesse, in welchen allenfalls giftige Stoffe zur Anwendung kommen, klar von den anderen Prozessschritten getrennt.

Auch ein Inline-Betrieb wäre, wie bereits im Zusammenhang mit der CVD, PVD, Sputter oder Heissprägetechnologie erwähnt, denkbar, bei welchem die ersten Hartkomponenten 10 im Takt der Mehrkomponenten Spritzgussmaschine oder einzelner getrennter Spritzgussmaschinen mit dem metallischen Überzug 44 versehen werden. Inline heisst in diesem Zusammenhang direkt zusammen gekoppelt: Bei einem Inline-Betrieb wird die Verbindung zwischen dem Spritzgiess- und dem Beschichtungsprozess vorzugsweise mit einem Umlaufenden Paletten- oder Logistiksystem sichergestellt, welches die Prozesse direkt d.h. ohne Unterbruch miteinander verbindet. Die verschiedenen Systeme bzw. Teilkomponenten des Systems sind somit über die Taktzeit gekoppelt; Fig. 32.

Die Zuführung der beschichteten Körper kann auf verschiedene Arten geschehen. Wenn die Bearbeitung Inline realisiert wird, werden die Körper beziehungsweise Spritzlinge vom Behälter-, Tray- Paletten- oder Logistiksystem direkt übernommen und mittels eines Handlings eingelegt. Bei Offline-Betrieb können die Körper auf verschiedene Arten zugeführt und eingelegt werden. Die Zuführung wird jeweils so ausgelegt, dass die geschaffene Beschichtung nicht beschädigt, d.h. zerkratzt wird. Der Transport der Teile zwischen den Prozessen kann die Körper als Schüttgut behandeln oder die Körper werden geordnet in Trays abgelegt. Die Bereitstellung für das Einlegen ins Werkzeug, im Fall einer Behandlung der Körper als Schüttgut, kann beispielsweise mittels Schwingfördern oder mittels einer Kaskadenzuführung erfolgen. Die auf diese Weise vereinzelten und in einen ausgerichteten Zustand gebrachten Körper werden anschliessend mit einem externen Handling in das Spritzgusswerkzeug eingelegt. Dieses Handling findet bei beiden Transportarten Anwendung und besitzt Greifer oder eine Saugeinrichtung zum Bewegen der Körper. Die Körper können je nach Werkzeugkonzept im offenen oder geschlossenen Zustand ins Spritzgusswerkzeug eingelegt werden. Bei konventioneller Werkzeugtechnologie erfolgen sowohl Entnahme als auch Beladung im offenen Zustand. Im Spritzgusswerkzeug werden die vom Handling eingebrachten Teile gehalten. Das Halten passiert vorzugsweise mittels mechanischen Greifern, welche direkt ins Spritzgusswerkzeug integriert sind. Es ist aber auch möglich, das Halten mittels Vakuumsaugern zu erreichen, sodass die Körper an den Kavitätenrand gesogen werden.

Vorzugsweise werden neuere Werkzeugkonzepte eingesetzt, bei denen die erste Hartkomponente 10 im geschlossenen Zustand des Werkzeuges entnommen werden kann. Das gleiche gilt für das Einlegen der beschichteten ersten Hartkomponente 10. Damit kann massgeblich Zykluszeit eingespart werden.

Der Prozess bzw. die Schnittstelle zwischen dem Spritzguss- und dem Beschichtungsprozess kann vom Produkt her optimiert werden. Es ist möglich, dass mittels Spritzguss angussähnliche Bereiche gestaltet werden, welche das Handling zwischen den Prozessen und in den Prozessen unterstützt.

Die im vorherigen Abschnitt beschriebene Aufsteckung, wie auch die standardmässige Anordnung der zu beschichtenden Körper hat zur Folge, dass die zu beschichtenden Körper entsprechend ausgestaltet sein müssen, damit das Handling im Prozess überhaupt möglich ist.

Es ist selbstverständlich auch möglich, in gleicher Art und Weise und mit einem analogen Aufbau versehen, wie die vorgestellten Zahnbürsten, Elektrozahnbürsten, Schallzahnbürsten, andere Körperpflegegeräte mit einem Behandlungskopf, wie beispielsweise Nassrasierer, Vibrationsnassrasierer, Maskarabürsten, Haarbürsten und andere Kosmetik- oder Körperpflegeprodukte herzustellen. Auch die entsprechende Herstellung von Haushaltsbürsten, wie beispielsweise Abwaschbürsten, Wischersets, Schuhbürsten, Schrubber, Besen oder Grillbürsten wären denkbar.

Ergänzend sei erwähnt, dass es auch möglich ist, eine weiche Komponente aus einem weichen Kunststoff mit einem metallischen Überzug zu versehen. Dazu wird die weiche Komponente an der Oberfläche gereinigt und gegebenenfalls in einem Flamm- oder Plasmaverfahren vorbehandelt. Danach wird ein Grundlack aufgebracht. Danach werden in einer Vakuumanlage die getrockneten Oberflächen durch ein Elektrodenverfahren mit atomarem Chrom oder Aluminium bedampft. Diese bilden mit dem Grundlack eine gute Verbindung. Falls ein hoher Glanz erwünscht ist, kann dann nachträglich ein Schutzlack aufgetragen werden.

Da die weiche Komponente einem nachträglichen Anspritzen einer harten Komponente mit betreffenden Drücken des Mehrkomponentenspritzgussverfahrens nicht standhalten bzw. sich erheblich verformen würde, wird die mindestens partiell mit dem metallischen Überzug versehene weiche Komponente vorzugsweise an den Bürstenkörper montiert, welcher mit entsprechenden Ausnehmungen, Durchlässen, Hinterschneidungen und dergleichen, versehen ist. Ein Überspritzen mit einer weiteren Komponente ist jedoch ausdrücklich auch denkbar, wenn entsprechende Massnahmen ergriffen werden. Dazu zählen ein minimaler Verarbeitungsdruck der weiteren Komponente, ein Überspritzen von dünnen Schichten der beschichteten Weichkomponente, sowie ein partielles Einklemmen und damit genaues positionieren der Weichkomponente. Die alternative Montage von Teilen aus weichem Kunststoff und Zahnbürstenkörper ist beispielsweise in US 5,339,482 offenbart. Da im montierten Zustand nur ein Teil der weichen Komponente 62 die Oberfläche der Zahnbürste bildet, ist es denkbar, nur diesen Teil mit einem metallischen Überzug zu versehen. Es ist auch denkbar, die mit dem metallischen Überzug versehene weiche Komponente mit dem Zahnbürstenkörper zu verkleben. Eine Verbindung durch Schweissen ist auch denkbar. Schlussendlich ist es auch möglich, Spangen, Federn oder dergleichen mechanische Hilfsteile zum Befestigen der mit dem metallischen Überzug versehenen weichen Komponente zu verwenden. In bevorzugter Weise ist die mit dem metallischen Überzug zu versehene weiche Komponente mit einer strukturierten Oberfläche versehen, beispielsweise sich wiederholenden Oberflächenstrukturen wie Noppen, Lamellen oder dergleichen. Dies erhöht den Halt und die Haftung auf der sonst glatten metallischen Oberfläche.

Mit dem vorliegenden Verfahren lassen sich auch Medizinalprodukte, wie beispielsweise Pumpen und dergleichen herstellen. Bevorzugt weisen die gemäss dem vorliegenden Verfahren hergestellten Körper für das Medizinalprodukt einen Hohlraum auf, der von der mit einem metallischen Überzug versehenen Kunststoffkomponente, insbesondere Hartkomponente, begrenzt ist.

## Patentansprüche

1. Zahnbürste mit einem eine erste Hartkomponente (10) aufweisenden Griffteil (64), einem daran anschliessenden Halsteil (52) und einem von diesem getragenen Kopfteil (14), wobei die erste Hartkomponente (10) im Griffteil (64) mindestens bereichsweise einen wesentlichen Anteil am Querschnitt (30) des Griffteils (64) einnimmt und wenigstens bereichsweise mit einem metallischen Überzug (44) versehen ist, der metallische Überzug (44) im Griffteil (64) wenigstens bereichsweise mit einer zweiten Komponente (48) mittels Spritzguss (46) überdeckt ist, wobei die erste Hartkomponente (10) und zweite Komponente (48), ohne Bildung eines Materialschlusses, mechanisch miteinander fest verbunden sind, wobei die zweite Komponente eine Hartkomponente (48) ist und die erste Hartkomponente (10) und zweite Komponente (48) ausschliesslich mechanisch miteinander fest verbunden sind, **dadurch gekennzeichnet, dass** die erste Hartkomponente mit dem metallischen Überzug vollständig überzogen ist.

2. Zahnbürste nach Anspruch 1, **dadurch gekennzeichnet, dass** der wesentliche Anteil mindestens 10%, vorzugsweise mindestens 20%, des Querschnitts (30) beträgt.

3. Zahnbürste nach Anspruch 1 oder 2, **dadurch gekennzeichnet, dass** die erste Hartkomponente (10) eine Formtrennlinie (68) aufweist und der metallische Überzug (44) ununterbrochen über die Formtrennlinie (68) hinweg verläuft.

4. Zahnbürste nach einem der Ansprüche 1 bis 3, **dadurch gekennzeichnet, dass** die zweite Hartkomponente (48) eine gegenüber der ersten Hartkomponente (10) freiliegende Zone aufweist und eine weiche Komponente (62) in dieser Zone mit der zweiten Hartkomponente (48) mittels Mehrkomponentenspritzguss, unter Bildung eines Materialschlusses, verbunden ist.

5. Zahnbürste nach einem der Ansprüche 1 bis 4, **dadurch gekennzeichnet, dass** die zweite Hartkomponente. (48), insbesondere form- und kraftschlüssig, mittels einer aufgrund des Spritzgussprozesses der zweiten Hartkomponente (48) über die erste Hartkomponente (10) wirkenden Schwundverbindung, mit der ersten Hartkomponente (10) fest verbunden ist.

6. Zahnbürste nach Anspruch 4, **dadurch gekennzeichnet, dass** die weiche Komponente (62) an dem metallischen Überzug (44) wenigstens bereichsweise anliegt.

7. Zahnbürste nach einem der Ansprüche 1 bis 6, **dadurch gekennzeichnet, dass** die erste Hartkomponente (10) wenigstens eine Verankerungsausnehmung (36, 36', 40, 40', 74), in welche die zweite Hartkomponente (48) zur Verankerung eingreift, oder wenigstens einen Verankerungsvorsprung (39), welcher von der zweiten Hartkomponente (48) zur Verankerung umschlossen ist, aufweist.

8. Zahnbürste nach Anspruch 7, **dadurch gekennzeichnet, dass** die Verankerungsausnehmung (36, 36', 74) durchgehend ausgebildet ist und die zweite Hartkomponente (48) darin eine Materialbrücke (84) bildet.

9. Zahnbürste nach Anspruch 8, **dadurch gekennzeichnet, dass** die zweite Hartkomponente (48) bei der durchgehenden Verankerungsausnehmung (36) die erste Hartkomponente (10) in Umfangsrichtung vollständig umschliesst.

10. Zahnbürste nach Anspruch 9, **dadurch gekennzeichnet, dass** die zweite Hartkomponente (48) infolge Materialschwund mit der Verankerungsausnehmung (36, 36', 40, 40', 74) beziehungsweise dem Verankerungsvorsprung (39), oder mittels anderer mechanischer Verankerungsmittel, unlösbar verbunden ist.

11. Zahnbürste nach Anspruch 10, **dadurch gekennzeichnet, dass** die unlösbare, Verbindung wasserdicht ist.

12. Zahnbürste nach einem der Ansprüche 1 bis 11, **dadurch gekennzeichnet, dass** der metallische Überzug (44) durch Galvanisieren, CVD (Chemical Vapour Deposition), PVD (Physical Vapour Deposition), Sputtern, Plasmabeschichtung, Decal- oder Heissprägen, oder ein anderes Dünnschichtverfahren, aufgebracht ist.

13. Zahnbürste nach einem der Ansprüche 1 bis 12, **dadurch gekennzeichnet, dass** die erste Hartkomponente (10) zur Verbesserung der Haftung des metallischen Überzugs (44) behandelt, vorzugsweise geätzt, aufgeraut, mit einem Primer oder einem Lack versehen ist.

14. Zahnbürste nach einem der Ansprüche 1 bis 13, **dadurch gekennzeichnet, dass** der metallische Überzug (44) in einem Kontaktbereich mit der zweiten Hartkomponente (48) oder allenfalls der weichen Komponente (62) zur Ermöglichung einer Haftung behandelt, vorzugsweise geätzt, aufgeraut oder mit einem Primer oder einem Lack überzogen ist.

15. Zahnbürste nach einem der Ansprüche 1 bis 14, **dadurch gekennzeichnet, dass** die erste Hartkomponente (10) Polyamid (PA), Polyester (PET), Acrylbuthadienstyrol (ABS), Styrolacrylnitril (SAN), Polypropylen (PP), Polycyclohexandimethanoltherasthalat (PCT; PCT-A (säuremodifiziert); PCT-G (glykolmodifiziert)), Polyethylen (PE), Polystyrol (PS), Styrolacrylnitril (SAN), Polymethylmethacrylat (PMMA), Polyvenilchlorid (PVC) oder Acrylbuthadienstyrol (ABS)aufweist.

16. Zahnbürste nach einem der Ansprüche 1 bis 15, **dadurch gekennzeichnet, dass** die zweite Hartkomponente (48) Polypropylen (PP), Polyester (PET), Polycyclohexandimethanoltherasthalat (PCT; PCT-A (säuremodifiziert); PCT-G (glykolmodifiziert)), Polyethylen (PE), Polystyrol (PS), Styrolacrylnitril (SAN), Polymethylmethacrylat (PMMA), Polyvenilchlorid (PVC) oder Acrylbuthadienstyrol (ABS) aufweist.

17. Zahnbürste nach einem der Ansprüche 1 bis 16, **dadurch gekennzeichnet, dass** die zweite Hartkomponente (48) und gegebenenfalls die weiche Komponente (62) einen Haftvermittler zur Verbindung mit dem metallischen Überzug (44) mittels Spritzguss, vorzugsweise Mehrkomponentenspritzguss aufweist.

18. Zahnbürste nach Anspruch 17, **dadurch gekennzeichnet, dass** der Haftvermittler Maleinsäureanhydride (MSA), EBA, SB/PE Blockcopolymerisat, SB/PP Blockcopolymerisat, SB-Blends oder eine Ethylen-Vinylacetat (EVA) Basis, wie EVAC, aufweist.

19. Zahnbürste nach Anspruch 4, **dadurch gekennzeichnet, dass** in einem Querschnitt der Zahnbürste die zweite Hartkomponente (48) den metallischen Überzug (44) und die weiche Komponente (62) die zweite Hartkomponente (48) teilweise überdecken.

20. Zahnbürste nach einem der Ansprüche 1 bis 19, **dadurch gekennzeichnet, dass** in der ersten Hartkomponente (10) oder der zweiten Hartkomponente (48) ein Hohlraum ausgebildet ist.

21. Verfahren zum Herstellen einer Zahnbürste mit einem eine erste Hartkomponente (10) aufweisenden Griffteil (64), einem daran anschliessenden Halsteil (52) und einem von diesem getragenen Kopfteil (14), bei welchem die erste Hartkomponente (10) mittels Spritzguss geformt wird und anschliessend mit einem metallischen Überzug (44) versehen wird, wobei die erste Hartkomponente (10) im Griffteil (64) mindestens bereichsweise einen wesentlichen Anteil am Querschnitt (30) des Griffteils (64) einnimmt, der metallische Überzug (44) im Griffteil (64) wenigstens bereichsweise mittels Spritzguss, insbesondere Mehrkomponentenspritzguss, mit einer zweiten Komponente(48) überdeckt wird, wobei die erste Hartkomponente (10) und zweite Komponente (48), ohne Bildung eines Materialschluss, mechanisch fest miteinander verbunden werden, wobei die zweite Komponente als Hartkomponente (48) gebildet wird und die erste Hartkomponente (10) und zweite Komponente (48) ausschliesslich mechanisch miteinander fest verbunden sind, **dadurch gekennzeichnet, dass** die erste Hartkomponente mit dem metallischen Überzug vollständig überzogen ist.

22. Verfahren nach Anspruch 21, **dadurch gekennzeichnet, dass** die erste Hartkomponente (10) im Spritzgussverfahren oder Mehrkomponentenspritzgussverfahren hergestellt, danach - vom Takt des Spritzgussverfahrens abgekoppelt - gelagert und mit dem metallischen Überzug (44) versehen wird, dann die mit dem metallischen Überzug (44) versehene erste Hartkomponente (10) in ein Spritzgusswerkzeug (86) oder ein Mehrkomponentenspritzgusswerkzeug eingelegt und mit einer zweiten Hartkomponente (46) bereichsweise überspritzt wird.

23. Verfahren nach Anspruch 21, **dadurch gekennzeichnet, dass** die erste Hartkomponente (10) in einem Spritzgusswerkzeug (86) oder Mehrkomponentenspritzgusswerkzeug hergestellt, dem Spritzgusswerkzeug (86) oder Mehrkomponentenspritzgusswerkzeug entnommen und - an den Takt des Spritzgussverfahrens beziehungsweise Mehrkomponentenspritzgussverfahrens gekoppelt - einer Überzugsstation - zum Versehen mit dem metallischen Überzug 44 - zugeführt wird, die mit dem metallischen Überzug (44) versehene erste Hartkomponente (10) in das Spritzgusswerkzeug oder Mehrkomponentenspritzgusswerkzeug eingelegt und mit der zweiten Hartkomponente (48) wenigstens bereichsweise überspritzt wird.

24. Verfahren nach einem der Ansprüche 21 bis 23, **dadurch gekennzeichnet, dass** an die zweite Hartkomponente (48) im Spritzgusswerkzeug oder (86) Mehrkomponentenspritzgusswerkzeug eine weiche Komponente (62) angespritzt wird, welche vorzugsweise den metallischen Überzug (44) wenigstens bereichsweise überdeckt.

## Claims

1. Toothbrush with a handle part (64), having a first hard component (10), a neck part (52), adjoining said handle part, and a head part (14), carried by said neck part, the first hard component (10) in the handle part (64) taking up a significant proportion of the cross section (30) of the handle part (64) at least in certain regions and being provided with a metallic coating (44) at least in certain regions, the metallic coating (44) in the handle part (64) being covered at least in certain regions by a second component (48) by means of injection molding (46), the first hard component (10) and the second component (48) being firmly connected to each other in a mechanical manner, without forming a material bond, the second component being a hard component (48) and the first hard component (10) and second component (48) being firmly connected to each other exclusively in a mechanical manner, **characterized in that** the first hard component is completely coated with the metallic coating.

2. Toothbrush according to claim 1, **characterized in that** the significant proportion is at least 10%, preferably at least 20%, of the cross section (30).

3. Toothbrush according to claim 1 or 2, **characterized in that** the first hard component (10) has a mold parting line (68) and the metallic coating (44) extends uninterruptedly over the mold parting line (68).

4. Toothbrush according to any one of claims 1 to 3, **characterized in that** the second hard component (48) has a zone that is free opposite to the first hard component (10) and a soft component (62) in this zone is connected with the second hard component (48) by means of multi-component injection molding, with forming a material bond.

5. Toothbrush according to any one of claims 1 to 4, **characterized in that** the second hard component (48) is firmly connected to the first hard component (10), in particular by positive and non-positive connection, by means of a shrinkage connection acting as a result of the injection-molding process of the second hard component (48) over the first hard component (10).

6. Toothbrush according to claim 4, **characterized in that** the soft component (62) lies against the metallic coating (44) at least in certain regions.

7. Toothbrush according to any one of claims 1 to 6, **characterized in that** the first hard component (10) has at least one anchoring clearance (36, 36', 40, 40', 74), in which the second hard component (48) engages for anchoring, or at least one anchoring projection (39), which is enclosed by the second hard component (48) for anchoring.

8. Toothbrush according to claim 7, **characterized in that** the anchoring clearance (36, 36', 74) is continuously formed and the second hard component (48) forms a material bridge (84) therein.

9. Toothbrush according to claim 8, **characterized in that** at the continuous anchoring clearance (36), the second hard component (48) completely encloses the first hard component (10) in the circumferential direction.

10. Toothbrush according to claim 9, **characterized in that** the second hard component (48) is undetachably connected as a result of material shrinkage to the anchoring clearance (36, 36', 40, 40', 74) respectively the anchoring projection (39), or by means of other mechanical anchoring means.

11. Toothbrush according to claim 10, **characterized in that** the undetachable connection is waterproof.

12. Toothbrush according to any one of claims 1 to 11, **characterized in that** the metallic coating (44) is applied by electrodeposition, CVD (Chemical Vapor Deposition), PVD (Physical Vapor Deposition), sputtering, plasma coating, decal or hot stamping, or some other thin-film process.

13. Toothbrush according to any one of claims 1 to 12, **characterized in that** the first hard component (10) is treated, preferably etched, roughened, provided with a primer or a lacquer, to improve the bonding of the metallic coating (44).

14. Toothbrush according to any one of claims 1 to 13, **characterized in that** the metallic coating (44) is treated, preferably etched, roughened, provided with a primer or a lacquer, in a contact region with the second hard component (48) or possibly with the soft component (62) to make bonding possible.

15. Toothbrush according to any one of claims 1 to 14, **characterized in that** the first hard component (10) comprises polyamide (PA), polyester (PET), acrylonitrile butadiene styrene (ABS), styrene acrylonitrile (SAN), polypropylene (PP), polycyclohexane dimethanol terephthalate (PCT; PCT-A (acid-modified); PCT-G (glycol-modified)), polyethylene (PE), polystyrene (PS), styrene acrylonitrile (SAN), polymethylmethacrylate (PMMA), polyvinyl chloride (PVC) or acrylonitrile butadiene styrene (ABS).

16. Toothbrush according to any one of claims 1 to 15, **characterized in that** the second hard component (48) comprises polypropylene (PP), polyester (PET), polycyclohexane dimethanol terephthalate (PCT; PCT-A (acid-modified); PCT-G (glycol-modified)), polyethylene (PE), polystyrene (PS), styrene acrylonitrile (SAN), polymethylmethacrylate (PMMA), polyvinyl chloride (PVC) or acrylonitrile butadiene styrene (ABS).

17. Toothbrush according to any one of claims 1 to 16, **characterized in that** the second hard component (48), and if appropriate the soft component (62), comprises an adhesion promoter for the connection to the metallic coating (44) by means of injection molding, preferably multi-component injection molding.

18. Toothbrush according to claim 17, **characterized in that** the adhesion promoter comprises maleic anhydrides (MSA), EBA, SB/PE block copolymer, SB/PP block copolymer, SB blends or an ethylene vinyl acetate (EVA) base, such as EVAC.

19. Toothbrush according to claim 4, **characterized in that** in a cross section of the toothbrush, the second hard component (48) partially covers the metallic coating (44) and the soft component (62) partially covers the second hard component (48).

20. Toothbrush according to any one of claims 1 to 19, **characterized in that** a hollow space is formed in the first hard component (10) or in the second hard component (48).

21. Method for producing a toothbrush with a handle part (64), having a first hard component (10), a neck part (52), adjoining said handle part, and a head part (14), carried by said neck part, in which the first hard component (10) is formed by means of injection molding and is subsequently provided with a metallic coating (44), the first hard component (10) in the handle part (64) taking up a significant proportion of the cross section (30) of the handle part (64) at least in certain regions, the metallic coating (44) in the handle part (64) being covered at least in certain regions by a second hard component (48) by means of injection molding, in particular multi-component injection molding, the first hard component (10) and the second component (48) being firmly connected to each other in a mechanical manner, without forming a material bond, the second component being a hard component (48) and the first hard component (10) and second component (48) being firmly connected to each other exclusively in a mechanical manner, **characterized in that** the first hard component (10) is completely coated with the metallic coating (44).

22. Method according to claim 21, **characterized in that** the first hard component (10) is produced by the injection-molding process or multi-component injection-molding process, after which - decoupled from the cycle of the injection-molding process - it is stored and provided with the metallic coating (44), then the first hard component (10), provided with the metallic coating (44), is placed into an injection-molding tool (86) or multi-component injection-molding tool and overmolded with a second hard component (46) in certain regions.

23. Method according to claim 21, **characterized in that** the first hard component (10) is produced in an injection-molding tool (86) or a multi-component injection-molding tool, is removed from the injection-molding tool (86) or multi-component injection-molding tool and - coupled to the cycle of the injection-molding process or multi-component injection-molding process - is fed to a coating station - for being provided with the metallic coating (44) -, the first hard component (10) provided with the metallic coating (44) is placed into the injection-molding (86) tool or multi-component injection-molding tool and overmolded with the second hard component (48) at least in certain regions.

24. Method according to any one of claims 21 to 23, **characterized in that** a soft component (62), which preferably covers the metallic coating (44) at least in certain regions, is molded onto the second hard component (48) in the injection-molding tool (86) or multi-component injection-molding tool.

## Revendications

1. Brosse à dents avec une partie de poignée (64), présentant un premier composant dur (10), une partie d'encolure (52) raccordée à la partie de poignée, et une partie de tête (14) supportée par la partie d'encolure, le premier composant dur (10) dans la partie de poignée (64) prenant une part significative de la section transversale (30) de la partie de poignée (64) au moins dans certaines régions et étant pourvu d'un revêtement métallique (44) au moins dans certaines régions, le revêtement métallique (44) dans la partie de poignée (64) étant couvert au moins dans certaines régions par un deuxième composant (48) au moyen de moulage par injection (46), le premier composant dur (10) et le deuxième composant (48) étant fermement connectés l'un à l'autre de façon mécanique, sans former une liaison de matériaux, le deuxième composant étant un composant dur (48) et le premier composant dur (10) ainsi que le deuxième composant (48) étant fermement connectés l'un à l'autre exclusivement de façon mécanique, **caractérisée en ce que** le premier composant dur est complètement couvert avec le revêtement métallique.

2. Brosse à dents selon la revendication 1, **caractérisée en ce que** la part significative est au moins 10%, préférablement au moins 20%, de la section transversale (30).

3. Brosse à dents selon la revendication 1 ou 2, **caractérisée en ce que** le premier composant dur (10) présente une ligne de séparation de moulage (68) et le revêtement métallique (44) s'étend de façon ininterrompue sur la ligne de séparation de moulage (68).

4. Brosse à dents selon l'une quelconque des revendications 1 à 3, **caractérisée en ce que** le deuxième composant dur (48) présente une zone libre opposée au premier composant dur (10) et un composant mou (62) dans cette zone est connecté avec le deuxième composant dur (48) au moyen de moulage par injection à plusieurs composants, en formant une liaison de matériaux.

5. Brosse à dents selon l'une quelconque des revendications 1 à 4, **caractérisée en ce que** le deuxième composant dur (48) est fermement connecté au premier composant dur (10), en particulier par coopération et par adhérence, au moyen d'une liaison par rétraction suite au procédé de moulage par injection du deuxième composant dur (48) sur le premier composant dur (10).

6. Brosse à dents selon la revendication 4, **caractérisée en ce que** le composant mou (62) est en contact avec le revêtement métallique (44) au moins dans certaines régions.

7. Brosse à dents selon l'une quelconque des revendications 1 à 6, **caractérisée en ce que** le premier composant dur (10) présente au moins un creux d'ancrage (36, 36', 40, 40', 74) dans lequel le deuxième composant dur (48) pénètre pour un ancrage, ou au moins une saillie d'ancrage (39) qui est entourée par le deuxième composant dur (48) pour un ancrage.

8. Brosse à dents selon la revendication 7, **caractérisée en ce que** le creux d'ancrage (36, 36', 74) est réalisé de façon continue et le deuxième composant dur (48) forme dedans un pont de matière (84).

9. Brosse à dents selon la revendication 8, **caractérisée en ce qu'**au creux continu d'ancrage (36), le deuxième composant dur (48) entoure complètement le premier composant dur (10) dans la direction circonférentielle.

10. Brosse à dents selon la revendication 9, **caractérisée en ce que** le deuxième composant dur (48) est connecté de façon indétachable suite à la rétraction du matériau avec le creux d'ancrage (36, 36', 40, 40', 74) respectivement avec la saillie d'ancrage (39), ou avec d'autres moyens d'ancrage mécanique.

11. Brosse à dents selon la revendication 10, **caractérisée en ce que** la connexion indétachable est étanche à l'eau.

12. Brosse à dents selon l'une quelconque des revendications 1 to 11, **caractérisée en ce que** le revêtement métallique (44) est appliqué par électrodéposition, CVD (dépôt chimique en phase gazeuse), PVD (dépôt physique en phase gazeuse), pulvérisation, revêtement par plasma, décalque ou marquage à chaud, ou par un autre procédé à couche mince.

13. Brosse à dents selon l'une quelconque des revendications 1 à 12, **caractérisée en ce que** le premier composant dur (10) est traité, préférablement corrodé, rendu rugueux, pourvu d'un primaire ou d'une laque, pour améliorer l'adhérence du revêtement métallique (44).

14. Brosse à dents selon l'une quelconque des revendications 1 à 13, **caractérisée en ce que** le revêtement métallique (44) est traité, préférablement corrodé, rendu rugueux, pourvu d'un primaire ou d'une laque, dans une région de contact avec le deuxième composant dur (48) ou éventuellement avec le composant mou (62) pour rendre une adhérence possible.

15. Brosse à dents selon l'une quelconque des revendications 1 à 14, **caractérisée en ce que** le premier composant dur (10) comprend du polyamide (PA), du polyester (PET), de l'acrylonitrile butadiène styrène (ABS), du styrène acrylonitrile (SAN), du polypropylène (PP), du polycyclohexane diméthanol téréphtalate (PCT; PCT-A (modifié en acide); PCT-G (modifié en glycol)), du polyéthylène (PE), du polystyrène (PS), du styrène acrylonitrile (SAN), du polyméthylméthacrylate (PMMA), du chlorure de polyvinyle (PVC) ou de l'acrylonitrile butadiène styrène (ABS).

16. Brosse à dents selon l'une quelconque des revendications 1 à 15, **caractérisée en ce que** le deuxième composant dur (48) comprend du polypropylène (PP), du polyester (PET), du polycyclohexane diméthanol téréphtalate (PCT; PCT-A (modifié en acide); PCT-G (modifié en glycol)), du polyéthylène (PE), du polystyrène (PS), du styrène acrylonitrile (SAN), du polyméthylméthacrylate (PMMA), du chlorure de polyvinyle (PVC) ou de l'acrylonitrile butadiène styrène (ABS).

17. Brosse à dents selon l'une quelconque des revendications 1 à 16, **caractérisée en ce que** le deuxième composant dur (48) et le cas échéant le composant mou (62) comprend un promoteur d'adhérence pour la connexion au revêtement métallique (44) au moyen de moulage par injection, préférablement de moulage par injection à plusieurs composants.

18. Brosse à dents selon la revendication 17, **caractérisée en ce que** le promoteur d'adhérence comprend de l'anhydride maléique (MSA), du EBA, un copolymère séquencé SB/PE, un copolymère séquencé SB/PP, des blends SB ou une base éthylène-acétate de vinyle (EVA), comme du EVAC.

19. Brosse à dents selon la revendication 4, **caractérisée en ce que** dans une section transversale de la brosse à dents, le deuxième composant dur (48) couvre partiellement le revêtement métallique (44) et le composant mou (62) couvre partiellement le deuxième composant dur (48).

20. Brosse à dents selon l'une quelconque des revendications 1 à 19, **caractérisée en ce qu'**une cavité est formée dans le premier composant dur (10) ou dans le deuxième composant dur (48).

21. Méthode pour la fabrication d'une brosse à dents avec une partie de poignée (64), présentant un premier composant dur (10), une partie d'encolure (52), raccordée à la partie de poignée, et une partie de tête (14), supportée par la partie d'encolure, dans laquelle le premier composant dur (10) est formé au moyen de moulage par injection et est ensuite pourvu d'un revêtement métallique (44), le premier composant dur (10) dans la partie de poignée (64) prenant une part significative de la section transversale (30) de la partie de poignée (64) au moins dans certaines régions, le revêtement métallique (44) dans la partie de poignée (64) étant couvert au moins dans certaines régions par un deuxième composant dur (48) au moyen de moulage par injection, en particulier de moulage par injection à plusieurs composants, le premier composant dur (10) et le deuxième composant (48) étant fermement connectés l'un à l'autre de façon mécanique, sans former une liaison de matériaux, le deuxième composant étant formé comme un composant dur (48) et le premier composant dur (10) ainsi que le deuxième composant (48) étant fermement connectés l'un à l'autre exclusivement de façon mécanique, **caractérisée en ce que** le premier composant dur (10) est complètement couvert avec le revêtement métallique (44).

22. Méthode selon la revendication 21, **caractérisée en ce que** le premier composant dur (10) est fabriqué par le procédé de moulage par injection ou procédé de moulage par injection à plusieurs composants, après quoi - découplé du cycle du procédé de moulage par injection - il est stocké et pourvu du revêtement métallique (44), ensuite le premier composant dur (10), pourvu du revêtement métallique (44), est placé dans un outil de moulage par injection (86) ou un outil de moulage par injection à plusieurs composants et surmoulé avec un deuxième composant dur (46) dans certaines régions.

23. Méthode selon la revendication 21, **caractérisée en ce que** le premier composant dur (10) est fabriqué dans un outil de moulage par injection (86) ou un outil de moulage par injection à plusieurs composants, est enlevé de l'outil de moulage par injection (86) ou de l'outil de moulage par injection à plusieurs composants et - couplé au cycle du procédé de moulage par injection ou du procédé de moulage par injection à plusieurs composants - est délivré à une station revêtement - pour être pourvu d'un revêtement métallique (44) -, le premier composant dur (10) pourvu du revêtement métallique (44) est placé dans l'outil de moulage par injection (86) ou dans l'outil de moulage par injection à plusieurs composants et surmoulé avec le deuxième composant dur (48) au moins dans certaines régions.

24. Méthode selon l'une quelconque des revendications 21 à 23, **caractérisée en ce qu'**un composant mou (62), qui préférablement couvre le revêtement métallique (44) au moins dans certaines régions, est moulé sur le deuxième composant dur (48) dans l'outil de moulage par injection (86) ou dans l'outil de moulage par injection à plusieurs composants.
